# EUROPEAN PATENT APPLICATION

(11) **EP 4 503 126 A1**
(43) Date of publication of application: **05.02.2025**
(21) Application number: 24169097.3
(22) Date of filing: 09.04.2024
(51) Int. Cl.: H01L 25/075, H01L 33/20, H01L 33/62

(54) **DISPLAY DEVICE USING SEMICONDUCTOR LIGHT EMITTING DIODES**

(30) Priority: 03.08.2023 KR 20230101829
(71) Applicant: LG Electronics Inc., Yeongdeungpo-gu Seoul 07336 (KR)
(72) Inventor: KIM, Donghyun, 06772 Seoul (KR); CHANG, Myungwhun, 06772 Seoul (KR); KIM, Wonsik, 06772 Seoul (KR); SONG, Hongsung, 06772 Seoul (KR)
(74) Representative: Vossius & Partner Patentanwälte Rechtsanwälte mbB

(57) **Abstract**

A display device is applicable to a display-related technical field, and a display device using micro light emitting diodes (LED) are disclosed. The display device using light emitting diodes includes a wiring substrate in which a plurality of unit pixels is defined, at least one electrode pad disposed in each of the unit pixels to define a plurality of unit sub-pixels, and at least one light emitting diode configured to have a tilt angle at which a side surface of the light emitting diode is inclined to one side, and a bonding surface electrically connected to the electrode pad. Two light emitting diodes adjacent to each other are arranged symmetrically with respect to the tilt angle, and a distance between two electrode pads adjacent to each other varies depending on positions of the electrode pads..

## Description

### TECHNICAL FIELD

The present disclosure is applicable to a display device-related technical field, and relates to, for example, a display device using a micro light emitting diode (LED).

### BACKGROUND

Recently, display devices with excellent characteristics such as thinness and flexibility are being developed in a field of display technology. Currently, commercially available major displays are represented by a liquid crystal display (LCD) and an organic light emitting diode (OLED).

In one example, a light emitting diode (LED), as a well-known semiconductor light emitting device that converts current into light, has been used as a light source for an image displayed in electronic devices including an information and communication device along with a GaP:N-based green LED, starting with commercialization of a red LED using a GaAsP compound semiconductor in 1962.

Recently, such light emitting diode (LED) has been gradually miniaturized and manufactured as a micrometer-sized LED to be used for pixels or flat lighting of the display device.

Sapphire, which is used as a substrate on which a gallium nitride-based semiconductor is grown, has a tilted crystal surface. For example, an R-plane has a crystal surface tilted along a m-axis. The ordinary sapphire may have the R-plane as a growth plane. Because the R-plane has a surface tilted with respect to a hexagonal prism crystal shape, the sapphire substrate and the gallium nitride-based semiconductor grown on the crystal surface of the sapphire substrate may have such a tilt angle.

In addition, such a tilt angle may also be formed as a light emitting diode is formed as the gallium nitride-based semiconductor on the sapphire substrate and then is cut in a direction of the crystal surface of the sapphire substrate.

Accordingly, when the light emitting diode is mounted on a wiring substrate in a general arrangement and emits light, an individual sub-pixel may be constructed in a state having an asymmetrical light distribution with respect to a direction for connecting two electrode pads with respect to one light emitting diode and the individual sub-pixels may constitute the display device.

As such, when the display device is formed with the individual sub-pixels with the asymmetrical light distribution, a problem in that, when viewing the display device from the outside, a color of a display appears differently depending on a viewing direction may occur.

In addition, an unintended parasitic capacitance may occur due to an electric field formed by a difference in polarity between a signal electrode/a common electrode of the light emitting diode.

Accordingly, even when the electric field is dissipated, discharge of the parasitic capacitance may not be normally performed, and thus a situation in which an adjacent light emitting diode is unintentionally turned on may occur.

The corresponding effect may be accumulated by the total number of light emitting diodes used in the display device, and finally, a ghost phenomenon may appear in a unit of a display product.

Therefore, there is a demand for a method capable of solving such problem.

### TECHNICAL PROBLEM

Accordingly, embodiments of the present disclosure are directed to a display device using semiconductor light emitting diodes (LEDs) that substantially obviate one or more problems due to limitations and disadvantages of the related art.

An object of the present disclosure is to provide a display device using semiconductor light emitting diodes (LEDs) that can offset biased light distribution of each light emitting diode (LED) affected by crystallinity of such LEDs.

Another object of the present disclosure is to provide a display device using semiconductor LEDs that can solve a problem of colors appearing differently depending on a viewing direction when the display device is viewed from the outside.

Another object of the present disclosure is to provide a display device using semiconductor LEDs that can reduce parasitic capacitance arising from a difference in electrical polarity between the LEDs.

Another object of the present disclosure is to provide a display device using semiconductor LEDs that can offset an electric field arising from a difference in electrical polarity between the LEDs.

Another object of the present disclosure is to provide a display device using semiconductor LEDs that can correct a difference in color between the left and right sides of the display by visually reinforcing some areas with weak colors when viewing the display from one direction.

Another object of the present disclosure is to provide a display device using semiconductor LEDs that can correct a color difference between the left and right sides of a display by visually reinforcing some areas with weak colors when viewing the display from one direction. Therefore, the present disclosure provides a display device using semiconductor LEDs that can obtain the effect of improving a color viewing angle in a final product stage of the display device.

Another object of the present disclosure is to provide a display device using semiconductor LEDs that can enable a brightness difference caused by light distribution characteristics not to appear, because a distance (pitch) between center points of the LEDs is constant when the display device is viewed from the side.

Another object of the present disclosure is to provide a display device using semiconductor LEDs, which can effectively remove various phenomena that may appear due to a tilt angle or a tilted light distribution pattern of light emitting diodes (LEDs), such as the phenomenon in which dark regions of the display are visible, the phenomenon in which vertical lines of the display are visible, the uneven light phenomenon, etc.

### TECHNICAL SOLUTION

In accordance with an aspect of the present disclosure, a display device using light emitting diodes may include: a wiring substrate in which a plurality of unit pixels is defined; at least one electrode pad disposed in each of the unit pixels to define a plurality of unit sub-pixels; and at least one light emitting diode configured to have a tilt angle at which a side surface of the light emitting diode is inclined to one side, and a bonding surface electrically connected to the electrode pad, wherein two light emitting diodes adjacent to each other are arranged symmetrically with respect to the tilt angle; and a distance between two electrode pads adjacent to each other varies depending on positions of the electrode pads.

In an exemplary embodiment, electrode polarities of the light emitting diodes connected to the two adjacent electrode pads may be arranged so that the same polarities face each other.

In an exemplary embodiment, the distance between the two adjacent electrode pads may vary by a shift of light emitting surfaces of the light emitting diodes due to the tilt angle.

In an exemplary embodiment, the distance between the two adjacent electrode pads may vary by compensating for a shift of light emitting surfaces of the light emitting diodes due to the tilt angle.

In an exemplary embodiment, the distance between the two adjacent electrode pads may vary in one direction in which the light emitting diodes that emit light of the same color are disposed.

In an exemplary embodiment, the distance between the two adjacent electrode pads may include a first distance and a second distance different from each other.

In an exemplary embodiment, the first distance and the second distance may be repeatedly arranged.

In an exemplary embodiment, polarities of the facing light emitting diodes corresponding to the two adjacent electrode pads may be identical.

In an exemplary embodiment, the distance between the two adjacent electrode pads may include: a first distance corresponding to a tilt angle at which light emitting surfaces of the light emitting diodes move closer to each other; and a second distance corresponding to a tilt angle at which light emitting surfaces of the light emitting diode move farther away from each other.

In an exemplary embodiment, the second distance may be smaller than the first distance.

In an exemplary embodiment, the light emitting surfaces may be top surfaces of the light emitting diodes.

In an exemplary embodiment, the distances between light emitting surfaces of the light emitting diodes, which correspond to the first distance and the second distance, may be equal to each other.

In an exemplary embodiment, the distances between bonding surfaces of the light emitting diodes, which correspond to the first distance and the second distance, may be different from each other.

In an exemplary embodiment, the tilt angle of the light emitting diode may be due to crystallinity of a semiconductor material of the light emitting diode.

In an exemplary embodiment, the light emitting diode may have a side cross-section or side surface in a longitudinal direction. That is, the side cross-section or the side surface may be formed in a parallelogram shape.

In accordance with another aspect of the present disclosure, a display device using light emitting diodes may include: a wiring substrate in which a plurality of unit pixels is defined; at least one electrode pad disposed in each of the unit pixels to define a plurality of unit sub-pixels; and at least one light emitting diode configured to have a tilt angle at which a side surface of the light emitting diode is inclined to one side, and a bonding surface electrically connected to the electrode pad. The light emitting diode includes first light emitting diodes configured to emit light of a first color in a first direction. The first light emitting diode includes a 1-1^{st} light emitting diode, a 1-2^{nd} light emitting diode, and a 1-3^{rd} light emitting diode that are consecutively arranged; and a first distance between the 1-1^{st} light emitting diode and the 1-2^{nd} light emitting diode is different from a second distance between the 1-2^{nd} light emitting diode and the 1-3^{rd} light emitting diode.

In an exemplary embodiment, the first distance is a distance between centers of bonding surfaces of the 1-1^{st} light emitting diode and the 1-2^{nd} light emitting diode; and the second distance is a distance between centers of bonding surfaces of the 1-2^{nd} light emitting diode and the 1-3^{rd} light emitting diode.

In an exemplary embodiment, the display device may further include: second light emitting diodes configured to emit light of a second color in a second direction; and third light emitting diodes configured to emit light of a third color in a third direction. Among the first light emitting diodes, the second light emitting diodes, and the third light emitting diodes, adjacent first, second, and third light emitting diodes form one unit pixel; and a direction of a tilt angle of each of the second light emitting diodes is different from at least one of a tilt angle of each of the first light emitting diodes and a tilt angle of each of the third light emitting diodes.

In an exemplary embodiment, in the unit pixel, the shifts of light emitting surfaces of the light emitting diodes may be equal to each other.

In an exemplary embodiment, the 1-1^{st} light emitting diode and the 1-2^{nd} light emitting diode may be arranged symmetrically with respect to the tilt angle so that electrode polarities in directions facing each other are identical.

In accordance with another aspect of the present disclosure, a display device using light emitting diodes may include: a wiring substrate in which a plurality of unit pixels is defined; at least one electrode pad disposed in each of the unit pixels to define a plurality of unit sub-pixels; and at least one light emitting diode configured to have a tilt angle at which a side surface of the light emitting diode is inclined to one side, and a bonding surface electrically connected to the electrode pad, wherein the light emitting diodes adjacent to each other in a first direction in which first light emitting diodes emitting light of the first color are arranged are arranged symmetrically with respect to the tilt angle so that electrode polarities of the facing light emitting diodes are identical; and a subpixel pitch defined by a distance between the electrode pads varies depending on a direction of the tilt angle.

In an exemplary embodiment, the subpixel pitch may include a first subpixel pitch and a second subpixel pitch.

In an exemplary embodiment, the first subpixel pitch and the second subpixel pitch may be alternately located in the first direction.

In an exemplary embodiment, the subpixel pitch may include a first subpixel pitch corresponding to a tilt angle at which light emitting surfaces of the light emitting diodes move closer to each other; and a second subpixel pitch corresponding to a tilt angle at which light emitting surfaces of the light emitting diodes move farther away from each other.

In an exemplary embodiment, the second subpixel pitch may be smaller than the first subpixel pitch.

In an exemplary embodiment, the distances between bonding surfaces of the light emitting diodes, which correspond to the first subpixel pitch and the second subpixel pitch, may be different from each other.

It is to be understood that both the foregoing general description and the following detailed description of the present disclosure are exemplary and explanatory and are intended to provide further explanation of the disclosure as claimed.

### ADVANTAGEOUS EFFECTS

According to one embodiment of the present disclosure, the following effects are obtained.

The display device using semiconductor light emitting diodes (LEDs) according to the embodiments of the present disclosure can offset biased light distribution of each light emitting diode (LED) affected by crystallinity of such LEDs. In other words, asymmetric light distribution of the LEDs can be offset.

The display device using semiconductor LEDs according to the embodiments of the present disclosure can solve the problem of colors appearing differently depending on a viewing direction when the display device is viewed from the outside.

The display device using semiconductor LEDs according to the embodiments of the present disclosure can reduce parasitic capacitance arising from a difference in electrical polarity between the LEDs.

The display device using semiconductor LEDs according to the embodiments of the present disclosure can solve a ghosting phenomenon that may occur due to such parasitic capacitance.

The display device using semiconductor LEDs according to the embodiments of the present disclosure can offset an electric field arising from a difference in electrical polarity between the LEDs.

The display device using semiconductor LEDs according to the embodiments of the present disclosure can correct a difference in color between the left and right sides of the display by visually reinforcing some areas with weak colors when viewing the display from one direction. Accordingly, the color viewing angle can be improved in the final product stage of the display device.

The display device using semiconductor LEDs according to the embodiments of the present disclosure can enable a brightness difference caused by light distribution characteristics not to appear, because a distance (pitch) between center points of the LEDs is constant when the display device is viewed from the side.

The display device using semiconductor LEDs according to the embodiments of the present disclosure can effectively remove various phenomena that may appear due to a tilt angle or a tilted light distribution pattern of light emitting diodes (LEDs), such as the phenomenon in which dark regions of the display are visible, the phenomenon in which vertical lines of the display are visible, the uneven light phenomenon, etc.

Furthermore, according to another embodiment of the present disclosure, there are additional technical effects not mentioned here. A person skilled in the art may understand this via the entire meaning of the present document and drawings.

### BRIEF DESCRIPTION OF THE DRAWINGS

The accompanying drawings, which are included to provide a further understanding of the disclosure and are incorporated in and constitute a part of this application, illustrate embodiment(s) of the disclosure and together with the description serve to explain the principle of the disclosure.
FIG. 1 is a schematic diagram illustrating a display device using semiconductor light emitting diodes (LEDs) according to an embodiment of the present disclosure.
FIG. 2 is a schematic diagram illustrating an example of subpixel arrangement of a display device using semiconductor light emitting diodes (LEDs) according to an embodiment of the present disclosure.
FIG. 3 is a schematic diagram illustrating another example of subpixel arrangement of a display device using semiconductor LEDs according to an embodiment of the present disclosure.
FIG. 4 is a schematic diagram illustrating the subpixel arrangements of FIGS. 2 and 4.
FIG. 5 is a schematic diagram illustrating the subpixel arrangement of a display device using semiconductor LEDs according to an embodiment of the present disclosure.
FIG. 6 is a schematic diagram illustrating the effect of subpixel arrangement of a display device using semiconductor LEDs according to an embodiment of the present disclosure.
FIG. 7 is a schematic diagram illustrating a process of forming the subpixel arrangement shown in FIG. 2.
FIG. 8 is a side photo image illustrating each light emitting diode (LED) of a display device using semiconductor LEDs according to an embodiment of the present disclosure.
FIG. 9 is a schematic diagram illustrating a tilt angle of each light emitting diode (LED) of a display device using semiconductor LEDs according to an embodiment of the present disclosure.
FIG. 10 is a view schematically illustrating sapphire crystal planes and sapphire crystal directions.
FIG. 11 is a view illustrating side photo images of light emitting diodes (LEDs) of a display device using semiconductor LEDs according to an embodiment of the present disclosure.
FIG. 12 is a schematic diagram illustrating tilt angles of light emitting diodes (LEDs) of a display device using semiconductor LEDs according to an embodiment of the present disclosure.
FIG. 13 is a view illustrating side photo images of light emitting diodes (LEDs) of a display device using semiconductor LEDs according to another embodiment of the present disclosure.
FIG. 14 is a schematic diagram showing an example of subpixel arrangement of a display device using semiconductor LEDs each having a tilt angle.
FIG. 15 is a schematic diagram illustrating an example of the subpixel arrangement of a display device using semiconductor LEDs each having a tilt angle according to a first embodiment of the present disclosure.
FIGS. 16 to 18 are schematic diagrams illustrating examples of arrangement of light emitting diodes (LEDs) each having a tilt angle.
FIG. 19 is a conceptual diagram illustrating a light emission pattern by a light emitting diode (LED) having a tilt angle.
FIG. 20 is a view schematically illustrating light distribution of the display device according to the arrangement of FIG. 14.
FIG. 21 is a view illustrating a microscopic analysis showing actual light emission of the display device according to the arrangement of FIG. 14.
FIG. 22 is a view illustrating light distribution viewed from the front of the display device according to the arrangement of FIG. 14 and a schematic diagram thereof.
FIG. 23 is a view illustrating light distribution viewed from the side of the display device according to the arrangement of FIG. 14 and a schematic diagram thereof.
FIG. 24 is a view illustrating light distribution of the display device according to the arrangement of FIG. 15.
FIG. 25 is a view illustrating light distribution viewed from the front of the display device according to the arrangement of FIG. 15 and a schematic diagram thereof.
FIG. 26 is a view illustrating light distribution viewed from the side of the display device according to the arrangement of FIG. 15 and a schematic diagram thereof.
FIG. 27 is a schematic diagram illustrating the subpixel arrangement of a display device using semiconductor LEDs each having a tilt angle according to a second embodiment of the present disclosure.
FIG. 28 is a schematic diagram illustrating the subpixel arrangement of a display device using semiconductor LEDs each having a tilt angle according to a third embodiment of the present disclosure.
FIG. 29 is a schematic diagram illustrating the subpixel arrangement of a display device using semiconductor LEDs each having a tilt angle according to a fourth embodiment of the present disclosure.
FIG. 30 is a schematic diagram illustrating the subpixel arrangement of a display device using semiconductor LEDs each having a tilt angle according to a fifth embodiment of the present disclosure.
FIG. 31 is a schematic diagram illustrating the subpixel arrangement of a display device using semiconductor LEDs each having a tilt angle according to a sixth embodiment of the present disclosure.
FIG. 32 is a schematic diagram illustrating the subpixel arrangement of a display device using semiconductor LEDs each having a tilt angle according to a seventh embodiment of the present disclosure.

### DETAILED DESCRIPTION

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

The display device described herein is a concept including all display devices that display information with a unit pixel or a set of unit pixels. Therefore, the display device may be applied not only to finished products but also to parts. For example, a panel corresponding to a part of a digital TV also independently corresponds to the display device in the present specification. The finished products include a mobile phone, a smartphone, a laptop, a digital broadcasting terminal, a personal digital assistant (PDA), a portable multimedia player (PMP), a navigation system, a slate PC, a tablet, an Ultrabook, a digital TV, a desktop computer, and the like.

However, it will be readily apparent to those skilled in the art that the configuration according to the embodiments described herein is applicable even to a new product that will be developed later as a display device.

In addition, the semiconductor light emitting diode mentioned in this specification is a concept including an LED, a micro LED, and the like, and may be used interchangeably therewith.

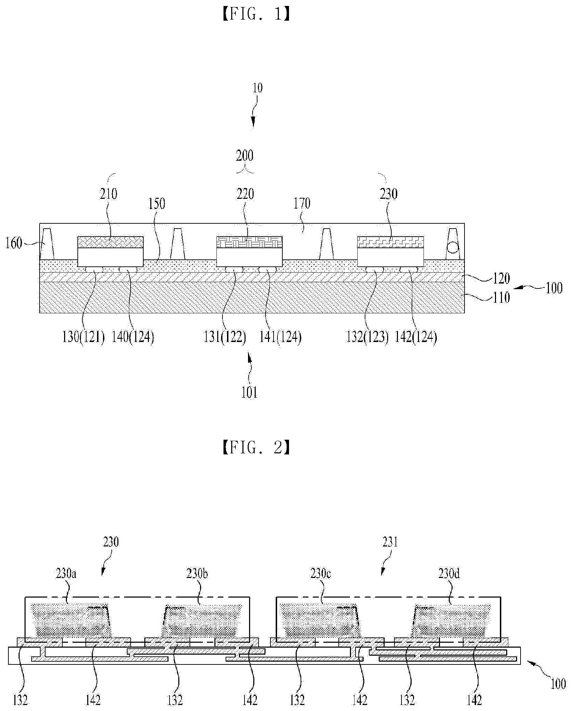

FIG. 1 is a schematic diagram of a display device using a semiconductor light emitting diode according to an embodiment of the present disclosure.

Referring to FIG. 1, in a display device 10, an individual unit pixel region 101 may be partitioned on a wiring substrate 100, and multiple light emitting diodes 200: 210, 220, and 230 may be installed within such unit pixel region 101.

In this regard, the individual light emitting diodes 210, 220, and 230 installed in the unit pixel region 101 may substantially correspond to sub-pixels, respectively. For example, three sub-pixels may be gathered to constitute one pixel. In FIG. 1, the three light emitting diodes 210, 220, and 230 may correspond to red, green, and blue light emitting diodes, respectively.

Each of the light emitting diodes 210, 220, and 230 may be electrically connected to a pair of electrode pads 130 and 140/131 and 141/132 and 142. In this case, as an example, the electrode pads 130, 131, and 132 (hereinafter, referred to as first electrode pads) arranged on one side in FIG. 1 may be connected to first wiring electrodes (signal electrodes or data electrodes) 121, 122, and 123, respectively.

In addition, the electrode pads 140, 141, and 142 arranged on the other side (hereinafter, referred to as second electrode pads) may be connected to a second wiring electrode (a common electrode or a scan electrode) 124. However, an opposite case thereof is also possible. In FIG. 1, the signal electrodes 121, 122, and 123 and the common electrode 124 are omitted due to an arrangement of electrodes and pads.

In one example, in some cases, the first electrode pads 130, 131, and 132 may respectively correspond to the signal electrodes 121, 122, and 123, and the second electrode pads 140, 141, and 142 may correspond to the common electrode 124.

Hereinafter, reference numerals of the electrode pads and the wiring electrodes are used interchangeably for description. That is, the electrode pads and the wire electrodes may be described using the same reference numerals.

As such, unit sub-pixels may be defined at points where the first wiring electrodes 121, 122, and 123 and the second wiring electrode 124 intersect each other.

In one example, when the first wiring electrodes 121, 122, and 123 are the signal electrodes (or the data electrodes), such first wiring electrodes 121, 122, and 123 or the first electrode pads 130, 131, and 132 may be connected to a TFT layer 120 on which a thin film transistor (TFT) is disposed. Accordingly, each of the light emitting diodes 210, 220, and 230 may be driven by switching driving resulted from such TFT layer 120.

In FIG. 1, the TFT layer 120 is briefly shown as a single layer, but the TFT layer 120 may include multiple TFT areas capable of performing the switching operation. For example, each TFT area may include a gate electrode, a source electrode, a drain electrode, an insulating layer disposed therebetween, a via electrode that may be connected to the first wiring electrodes 121, 122, and 123 or the first electrode pads 130, 131, and 132, and the like. A detailed description of this is omitted. Each of such TFT areas may be connected to each of the light emitting diodes 210, 220, and 230.

The multiple light emitting diodes 200; 210, 220, and 230 may be installed to be electrically connected onto the wiring electrodes 121, 122, 123, and 124 to form individual sub-pixels.

As mentioned above, such light emitting diodes 200 may include the red light emitting diode 210, the green light emitting diode 220, and the blue light emitting diode 230, and such three light emitting diodes 210, 220, and 230 may form the individual sub-pixels and be repeatedly positioned on the wiring substrate 100. Such light emitting diodes 210, 220, and 230 may include at least one of an organic light emitting diode and an inorganic light emitting diode. For example, the light emitting diodes 210, 220, and 230 may be the inorganic semiconductor light emitting diodes (light emitting diodes; LEDs).

Such semiconductor light emitting diode (LED) 200 may have a size of a micrometer (*µ*m) unit. The micrometer (*µ*m) size may mean that a width of at least one surface of the light emitting diode 200 has a size of several to hundreds of micrometers (*µ*m).

The TFT layer 120 may be positioned on a substrate 110, and an insulating layer 150 may be coated on the TFT layer 120. Such insulating layer 150 may be coated on a connection portion between the wiring electrodes 121, 122, 123, and 124, the electrode pads 130, 131, 132/140, 141, and 142, and the light emitting diodes 210, 220, and 230.

For example, the individual light emitting diodes 210, 220, and 230 may be separated from each other by a partition wall 160. In addition, a cover layer 170 may be positioned on the light emitting diodes 210, 220, and 230 and the partition wall 160.

As described above, the light emitting diodes 210, 220, and 230 may form the individual sub-pixels and be repeatedly positioned on the wiring substrate 100. For example, each pixel region 101 may be repeatedly disposed on the wiring substrate 100.

In this regard, the pixel regions 101 may be repeatedly positioned along one line of the data electrodes (the first wiring electrodes) 121, 122, and 123 or line of the scan electrode (the second wiring electrode) 124 in a longitudinal direction. For example, in FIG. 1, the red light emitting diode 210, the green light emitting diode 220, and the blue light emitting diode 230 may be repeatedly positioned along a left and right direction. For example, a red light emitting diode of an adjacent pixel region may be positioned on a right side of the blue light emitting diode 230.

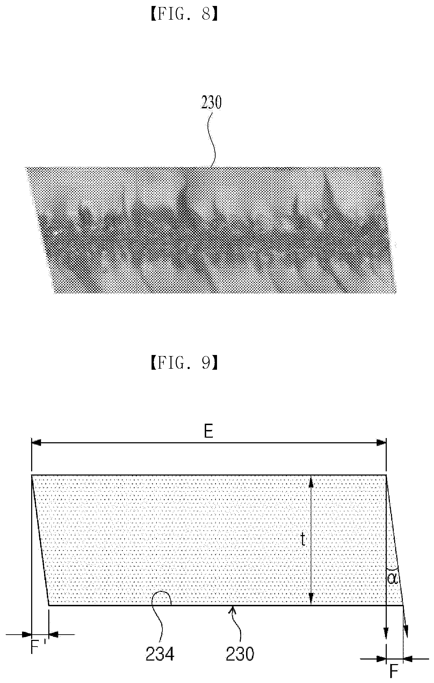

In one example, another data electrode (first wiring electrode) line or scan electrode (second wiring electrode) line adjacent to one data electrode (first wiring electrode) line or scan electrode (second wiring electrode) line in a parallel manner may be located (see FIG. 8). In this regard, a pixel region 102 (see FIG. 8) having the same arrangement of the light emitting diodes 210, 220, and 230 as the pixel region 101 may be located on the adjacent data electrode (first wiring electrode) line or scan electrode (second wiring electrode) line.

In this case, light emitting diodes having the same color may be located adjacent to each other in adjacent pixel regions. For example, the red light emitting diode 210, the green light emitting diode 220, and the blue light emitting diode 230 may be repeatedly positioned along the data electrode (first wiring electrode) line or the scan electrode (second wiring electrode) line, but light emitting diodes having the same color may be repeatedly positioned in a direction perpendicular to such data electrode (first wiring electrode) line or the scan electrode (second wiring electrode) line.

In this regard, according to one embodiment of the present disclosure, two adjacent light emitting diodes may have different arrangements. For example, referring to FIG. 1, the red light emitting diode 210 and the green light emitting diode 220 adjacent to the red light emitting diode 210 may have different arrangements.

For example, in the red light emitting diode 210, a first-type electrode, for example, an N-type electrode, may be positioned on the first wiring electrode 130, and in the green light emitting diode 220, a second-type electrode, for example, a P-type electrode, may be positioned on the first wiring electrode 131. Such different arrangements may also be made on the green light emitting diode 220 and the blue light emitting diode 230.

That is, the red light emitting diode 210 and the green light emitting diode 220 adjacent to such red light emitting diode 210 may have symmetrical arrangements with respect to electrode positions of the respective light emitting diodes 210 and 220.

In one example, a light emitting diode (e.g., the red light emitting diode 210) located in one pixel region 101 and a light emitting diode (e.g., the red light emitting diode 210) located in the adjacent pixel region 102 may have symmetrical arrangements with respect to the electrode positions as described above.

In other words, on the wiring substrate 100, a first light emitting diode 210 located in the first pixel region 101 and installed in a first arrangement, and a second light emitting diode 210 located in the second pixel region 102 adjacent to such first pixel region 101 and installed in a second arrangement symmetric with respect to the first arrangement may be positioned.

With the first and second arrangements of the light emitting diodes 210 as described above, a parasitic capacitance generated from a difference in electrical polarity between the first light emitting diode and the second light emitting diode may be reduced.

In addition, with the first arrangement and the second arrangement of the light emitting diodes 210 as described above, an electric field generated from the difference in the electric polarity between the first light emitting diode and the second light emitting diode may be canceled.

The light emitting diodes (LEDs) 210 having these different arrangements and the effects thereof will be described in detail later.

FIG. 2 is a schematic diagram illustrating an example of subpixel arrangement of a display device using semiconductor light emitting diodes (LEDs) according to an embodiment of the present disclosure.

Referring to FIG. 2, light emitting diodes (230a, 230b, 230c, 230d) may be symmetrically arranged on a wiring substrate 100. This arrangement may correspond to a state in which the light emitting diodes (LEDs) are arranged in parallel in one direction.

As mentioned above, the light emitting diodes (230a, 230b, 230c, 230d) may have asymmetric light distributions (a, b; see FIG. 2) with respect to the direction along which a first-type electrode 235 and a second-type electrode 237 are connected to each other. In addition, each of the light emitting diodes (230a, 230b, 230c, 230d) may have an asymmetric light distribution with respect to the direction along which the first electrode pad 132 and the second electrode pad 142 are connected to each other.

For example, each of the first LED 230a and the third LED 230c may have a light distribution (a) that is biased to the left. This biased structure may correspond to the first arrangement. In addition, the second LED 230b located between the first LED 230a and the third LED 230c and the fourth LED 230d located on the right side of the third LED 230c may have a light distribution (b) biased to the right. This biased structure may correspond to the second arrangement.

This structure may be a result of material characteristics of at least one of a substrate 231 and a semiconductor layer 232. For example, the above-described phenomenon may occur because the crystal structure of at least one of the substrate 231 and the semiconductor layer 232 has an inclined shape.

FIG. 2 shows a state in which each of the LEDs (230a, 230b, 230c, 230d) has an inclined crystal structure. In particular, considering a region (hereinafter, a first region) 230 where two adjacent pixels are paired, the first LED 230a of one pixel and the second LED 230b of the other pixel may have tilt angles that are symmetrical to each other. For example, the first LED 230a and the second LED 230b may be inclined in a direction away from each other. In addition, even in the second region 231 adjacent to the first region 230, the fourth LED 230d of the other pixel and the third LED 230c may have tilt angles that are symmetrical to each other.

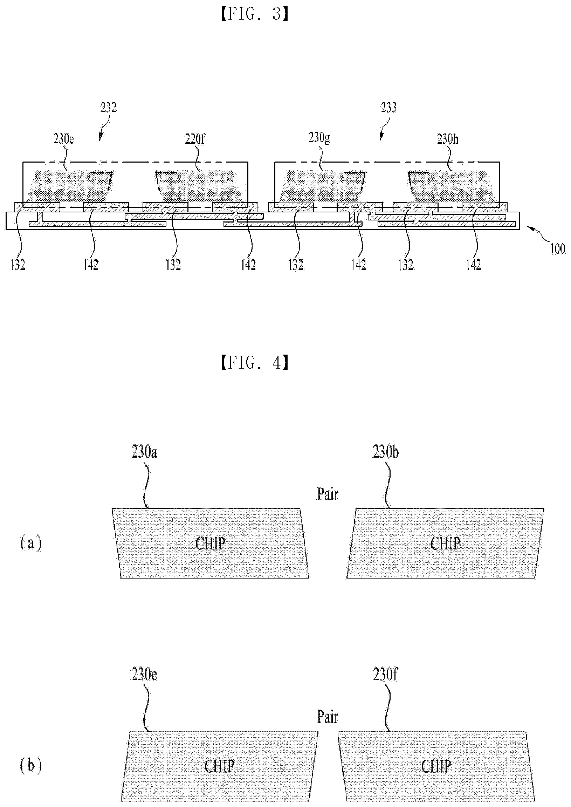

FIG. 3 is a schematic diagram illustrating another example of subpixel arrangement of a display device using semiconductor LEDs according to an embodiment of the present disclosure.

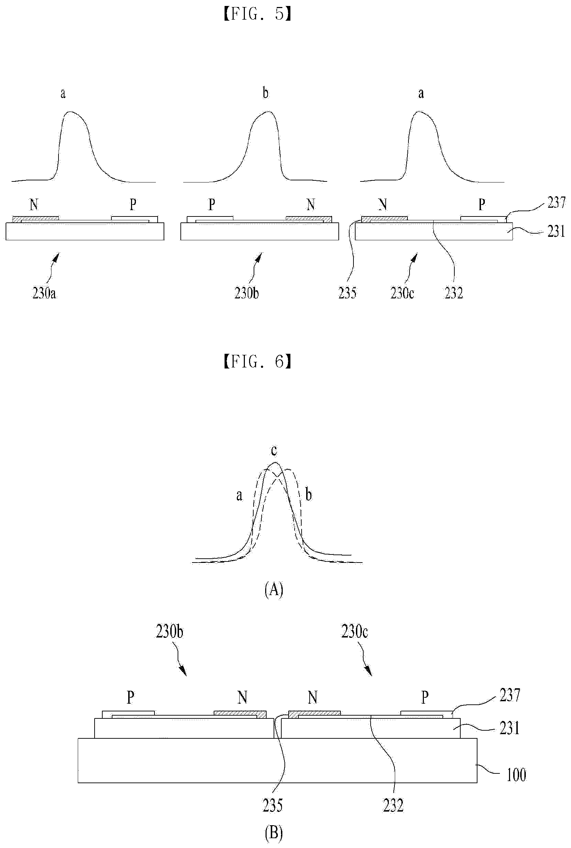

Referring to FIG. 3, light emitting diodes (230e, 230f, 230g, 230h) are symmetrically installed on the wiring substrate 100. This may correspond to a state in which the light emitting diodes (LEDs) shown in FIG. 6 are arranged in parallel.

As mentioned above, the light emitting diodes (230e, 230f, 230g, 230h) may have asymmetric light distribution (a, b) with respect to the direction along which the first-type electrode 235 and the second-type electrode 237 are connected to each other. In addition, each of the LEDs (230e, 230f, 230g, 230h) may have an asymmetric light distribution (a, b; see FIGS. 5 and 6) with respect to the direction along which the first electrode pad 132 and the second electrode pad 142 are connected to each other.

FIG. 3 shows a state in which each of the LEDs (230e, 230f, 230g, 230h) has an inclined crystal structure. In particular, considering a region (hereinafter, a third region) 232 where two adjacent pixels are paired, the fifth LED 230e of one pixel and the sixth LED 230f of the other pixel may have tilt angles that are symmetrical to each other. For example, the fifth LED 230e and the sixth LED 230f may be inclined in a direction toward which they approach each other. In addition, even in the fourth region 233 adjacent to the third region 232, the eighth LED 230h of the other pixel and the seventh LED 230g may have tilt angles that are symmetrical to each other.

FIG. 4 is a diagram schematically illustrating the subpixel arrangements of FIGS. 2 and 3.

FIG. 4(a) schematically shows a state in which the first LED 230a and the second LED 230b (denoted by "Pair") are arranged to have inclined angles in a direction away from each other in the first region 230 of FIG. 2. That is, the distance between the first LED 230a and the second LED 230b may gradually increase in the direction from the bottom surface to the top surface of the first and second LEDs 230a and 230b.

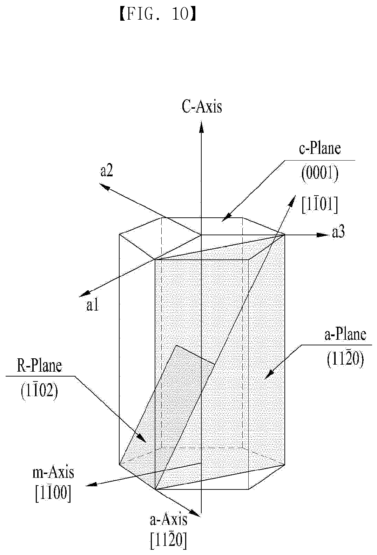

In addition, FIG. 4(b) schematically shows a state in which the fifth LED 230e and the sixth LED 230f (denoted by "Pair") in the third region 232 of FIG. 10 are arranged to have inclined angles in the direction toward which they approach each other. That is, the distance between the first LED 230a and the second LED 230b may gradually decrease in the direction from the bottom surface to the top surface of the first and second LEDs 230a and 230b.

As described above, when LEDs are symmetrically arranged in pairs with adjacent pixels, the biased light distributions (a, b) resulting from the crystal structure of the LEDs may offset from each other. In other words, the problem of colors appearing differently depending on the viewing direction when the display device is viewed from the outside can be solved.

FIG. 5 is a schematic diagram illustrating the subpixel arrangement of the display device using semiconductor LEDs according to an embodiment of the present disclosure.

FIG. 5 shows a state in which the first LED 230a and the second LED 230b adjacent to each other are located to respectively have a first arrangement and a second arrangement different from each other. Additionally, the second LED 230b and the third LED 230c may also be located to have different arrangements from each other.

For example, the first LED 230a and the third LED 230c may be located in a first arrangement, and the second LED 230b disposed between the first LED 230a and the third LED 230c may be located in a second arrangement.

At this time, the first LED 230a, the second LED 230b, and the third LED 230c may all be light emitting diodes (LEDs) that emit light of the same color. For example, the first LED 230a, the second LED 230b, and the third LED 230c may all be blue LEDs.

Here, the first arrangement may be an arrangement in which the N electrode 235 is located on the left in FIG. 5, and the P electrode 237 is located on the right in FIG. 5. In each LED (230a, 230b, 230c), a semiconductor layer 232 may be located on the substrate 231, and a first-type electrode (e.g., N-type electrode 235) and a second-type electrode (e.g., P-type electrode 237) may be arranged to contact the semiconductor layer 232.

That is, each LED (230a, 230b, 230c) may include a substrate 231, a semiconductor layer 232, a first-type electrode 235, and a second-type electrode 237. At this time, the respective LEDs (230a, 230b, 230c) may have different arrangements with respect to the direction in which the first-type electrode 235 and the second-type electrode 237 are connected to each other.

Referring to FIG. 5, the LED (230a, 230b, 230c) may have asymmetric light distribution ("a" or "b") with respect to the direction along which the first-type electrode 235 and the second-type electrode 237 are connected to each other. For example, the first LED 230a and the third LED 230c may have light distribution (a) that is biased to the left. This may correspond to the first arrangement. Additionally, the second LED 230b located between the first LED 230a and the third LED 230c may have the light distribution (b) that is biased to the right. This structure may correspond to the second arrangement.

This structure may be a result of material characteristics of at least one of the substrate 231 and the semiconductor layer 232. For example, the above-described phenomenon may occur because the crystal structure of at least one of the substrate 231 and the semiconductor layer 232 has an inclined shape. This will be described in detail later.

FIG. 6 is a schematic diagram illustrating the effect of subpixel arrangement of the display device using semiconductor LEDs according to an embodiment of the present disclosure.

Referring to FIG. 6, LEDs (230b, 230c) may be installed on the wiring substrate 100 to form subpixels.

At this time, referring to FIG. 6(B), the wiring substrate 100 may include wiring electrodes (123, 124) including the first wiring electrode 123 and the second wiring electrode 124 arranged on the wiring substrate 100, as described above with reference to FIG. 1. The LEDs (230b, 230c) in each unit pixel region are electrically connected to the first wiring electrode 123 and the second wiring electrode 124. That is, the subpixel arrangement of FIG. 6 may correspond to the case of the blue LED 230 of FIG. 1.

Here, referring to FIGS. 6(A) and 6(B) together, the LEDs (230b, 230c) may include the first LED 230b and the second LED 230c. The first LED 230b may be disposed in the first pixel region and may be installed to have the first arrangement. The second LED 230c may be disposed in the second pixel region adjacent to the first pixel region and may be installed to have the second arrangement symmetrical to the first arrangement.

Each of the first light emitting diode 230b and the second light emitting diode 230c may include the substrate 231, the semiconductor layer 232, the first-type electrode 235, and the second-type electrode 237. In this regard, the first light emitting diode 230b and the second light emitting diode 230c may have different arrangements with respect to the direction for connecting the first-type electrode 235 and the second-type electrode 237 to each other.

Accordingly, the light distribution a biased to one side by the first arrangement and the light distribution b biased to the other side by the second arrangement may be merged together to form a light distribution 'c' that is not biased and faces the center. That is, the asymmetrical light distributions may be canceled by the first arrangement of the first light emitting diode 230b and the second arrangement of the second light emitting diode 230c as described above.

In this regard, as described above, the first light emitting diode 230b and the second light emitting diode 230c may be light emitting diodes that emit light of the same color located in the adjacent pixel regions, for example, the blue light emitting diodes.

When a positive voltage is applied to a light emitting diode (LED) with a PN junction structure, charges and holes recombine with each other in an area where a P-area and an N-area meet each other to emit light. In this regard, a portion where the greatest amount of light is emitted is not a center of the area where the P-area and the N-area meet each other, but is biased. Therefore, when a display is manufactured with such an LED, a color of the display may appear differently depending on a direction for viewing the display.

However, as described above, when the first arrangement of the first light emitting diode 230b and the second arrangement of the second light emitting diode 230c are symmetrical with each other, a color difference of the display perceived on left and right sides when viewing the display from one side may be compensated for by visually reinforcing an area with weak color. Therefore, an effect of enhancing a color viewing angle in a final product stage of the display device may be obtained.

In addition, an electric field formed by a difference in polarity between the light emitting diodes 230b and 230c may be removed by the symmetrical arrangements of the first light emitting diode 230b and the second light emitting diode 230c, so that a parasitic capacitance may be prevented from being generated. In addition, the ghost phenomenon that may occur due to such parasitic capacitance may be improved.

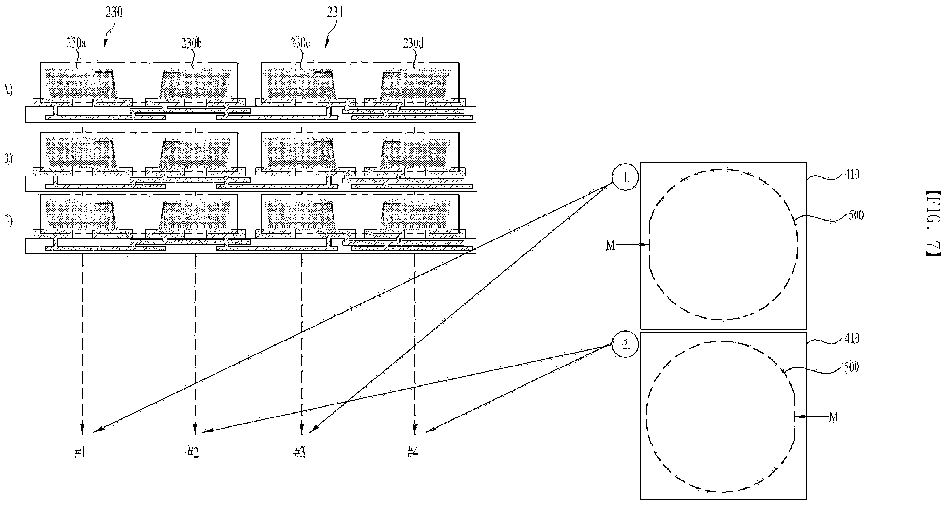

FIG. 7 is a schematic diagram illustrating a process of forming the subpixel arrangement shown in FIG. 2.

An example of a method of transferring light emitting diodes (LEDs) to have different arrangements will be briefly described with reference to FIG. 7.

For example, the LEDs (230a, 230c) are first transferred to odd columns of electrode pads (#1, #3, etc.) on the wiring substrate. Thereafter, the positions of the LEDs are rotated 180 degrees and then the LEDs (230a, 230c) are transferred to even columns of electrode pads (#2, #4, etc.) on the wiring substrate.

The LEDs (230a~230d) may be transferred to the wiring substrate after being transferred to the transfer substrate 410 while being located on the wafer 500. Here, the transfer substrate 410 may be, for example, a blue tape.

First, the LEDs (230a, 230c) may be transferred to the transfer substrate 410 in a state of the same arrangement as the upper side ○,1 (i.e., in a state in which the reference point M of the wafer 500 is located on the left).

Subsequently, the LEDs (230a, 230c) transferred to the transfer substrate 410 may be transferred to odd columns of electrode pads (#1, #3, etc.) of the wiring substrate.

Thereafter, in a state in which the wafer 500 is rotated 180 degrees as shown in ○,2 on the lower side (i.e., in a state in which the reference point M of the wafer 500 is located on the right), the LEDs (230b, 230d) may be transferred to the transfer substrate 410.

Subsequently, the LEDs (230b, 230d) transferred to the transfer substrate 410 may be transferred to electrode pads (#2, #4, etc.) of even columns of the wiring substrate.

Through the above-described process, the LEDs (230a~230h) arranged as shown in FIGS. 2 to 4 can be transferred onto the wiring substrate.

FIG. 8 is a side photo image illustrating each light emitting diode (LED) of the display device using semiconductor LEDs according to an embodiment of the present disclosure. FIG. 9 is a schematic diagram illustrating a tilt angle of each light emitting diode (LED) of the display device using semiconductor LEDs according to an embodiment of the present disclosure.

FIG. 8 is an enlarged photo image showing a side surface of the blue LED 230. FIG. 8 may represent a sapphire substrate that forms most of the thickness of the blue LED 230. As shown in FIG. 9, the tilt angle α of the blue LED 230 may be approximately 10 degrees. Additionally, as an example, the thickness (t) of the blue LED 230 may be 80 µm.

However, a gallium nitride semiconductor layer located on the sapphire substrate may also have the same or similar tilt angle. In some cases, the sapphire substrate may be removed after the light emitting diodes (LEDs) are manufactured. In this case, the gallium nitride-based semiconductor layer, rather than the substrate, of the light emitting diode (LED) may have the above tilt angle.

In this way, the LEDs (210, 220, 230) may have cross-sections or side surfaces formed in parallelograms.

According to this tilt angle (α), there is a deviation (shift or offset) (F, F') of the light emitting diode (LED) 230 between the light emitting surface (E) of the blue LED 230 and the opposite surface (hereinafter referred to as a bonding surface) 234 of the light emitting surface. Such deviations (F, F') can be considered as the amount of variation between the joining surface 234 and the light emitting surface (E) for the ideal case where the cross-section or the side surface of the LED 230 is formed in a rectangular shape. Hereinafter, for convenience of description, these deviations (F, F') may also be referred to as shifts.

Accordingly, a difference in length/area may occur between the bonding surface 234 and the light emitting surface (E) of the LED 230 as denoted by the shift (F, F'). For example, the position of the LED 230 viewed from the light emitting surface (E) may be different from the position of the LED 230 viewed from the bonding surface (234).

For example, as in a general case, when subpixels are configured by arranging the electrode pads (132, 142) at regular intervals (pitch) based on the bonding surface 234 of the LED 230, the distance between the light emitting surfaces (E) may increase or decrease by the shift (F or F').

Therefore, in a process of manufacturing a display device using the LEDs (210, 220, 230), when the spacing between the electrode pads (130, 140/131, 141/132, 142) to which the LEDs (210, 220, 230) are connected is set to a subpixel pitch in response to the bonding surfaces 234 of the LEDs (210, 220, 230), the subpixel pitch may be changed by the shifts (F, F') when viewed from the light emitting surface (E).

Here, the tilt angle (α) of the blue LED 230 may be the same on both sides of the LED 230 in the longitudinal direction. In this case, the shifts (F, F') on both sides of the blue LED 230 in the longitudinal direction may be equal to each other (i.e., F = F').

The above-described matters can also be equally applied to the red LED 210 or the green LED 220 rather than the blue LED 230.

Considering the above-described case, in a process of manufacturing the display device using the LEDs (210, 220, 230), when the electrode pads (130, 140/131, 141/132, 142) to which the LEDs (210, 220, 230) are connected is set to a subpixel pitch in response to the light emitting surfaces (E) of the LEDs (210, 220, 230), a uniform subpixel pitch can be obtained on the light emitting surface (E) side regardless of the shift (F, F'). In this case, the spacing between the electrode pads (130, 140/131, 141/132, 142) may vary by compensating for the shifts (F, F').

The above-described matters will be described in detail later.

FIG. 10 is a view schematically illustrating sapphire crystal planes and sapphire crystal directions. Sapphire may be used as a growth substrate for LEDs made of gallium nitride-based semiconductors.

Referring to FIG. 10, sapphire has inclined crystal planes. For example, the R-plane may have a crystal plane inclined toward the m-axis. In general, sapphire may have the R-plane as its own growth plane. As shown in FIG. 10, since the R-plane has a tilted surface with respect to a hexagonal pillar crystal shape, the sapphire substrate and the gallium nitride-based semiconductor grown on the crystal plane of the sapphire substrate may have such an inclined tilt angle.

Additionally, such a tilt angle may also be formed due to cutting in the direction of the crystal plane of the sapphire substrate after the LED is formed with a gallium nitride-based semiconductor on the sapphire substrate, so that the above-described tilt angle can be formed.

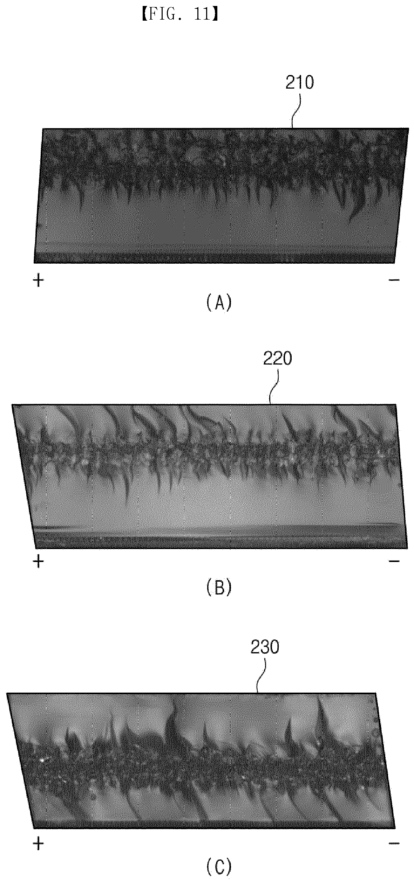

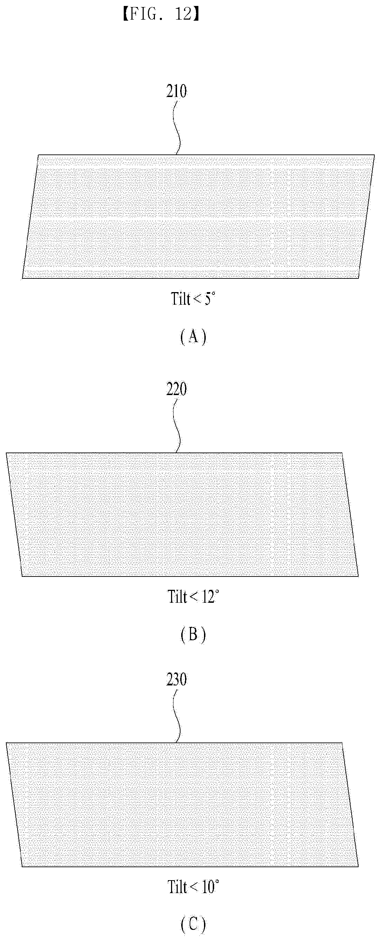

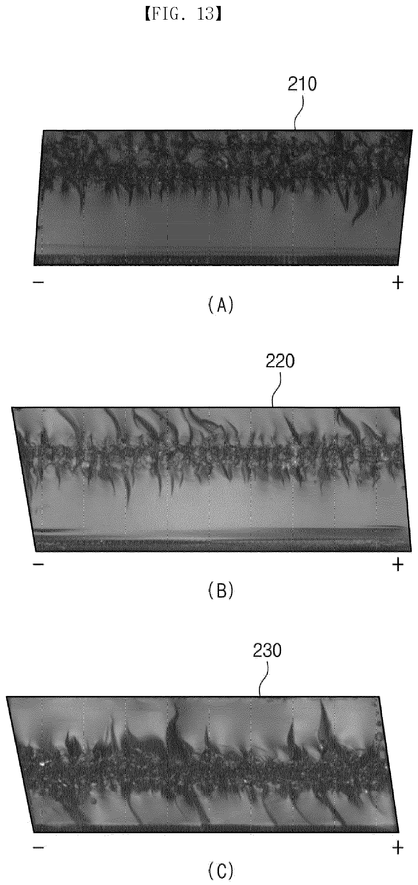

FIG. 11 is a view illustrating side photo images of light emitting diodes (LEDs) of the display device using semiconductor LEDs according to an embodiment of the present disclosure. FIG. 12 is a schematic diagram illustrating tilt angles of light emitting diodes (LEDs) of the display device using semiconductor LEDs according to an embodiment of the present disclosure. FIG. 13 is a view illustrating side photo images of light emitting diodes (LEDs) of the display device using semiconductor LEDs according to another embodiment of the present disclosure.

Referring to FIGS. 11 and 12, light emitting diodes (LEDs) that can be used in a display may have various tilt angles. For example, each of the LEDs shown in FIGS. 11(A) and 12(A) may have a tilt angle of 5 degrees or less in one direction.

In addition, each of the LEDs shown in FIGS. 11(B) and 12(B) may have a tilt angle of 12 degrees or less in a direction opposite to the tilt angle of the LEDs shown in FIGS. 11(A) and 12(A).

Additionally, the LEDs shown in FIGS. 11(C) and 12(C) may have a tilt angle of 10 degrees or less in the same direction as the tilt angle of the LEDs shown in FIGS. 11(B) and 12(B).

As described above, the LED may have a parallelogram structure with a side cross-section inclined to one side. As a result, the LED may have a light emitting pattern that is uneven and biased to one side with respect to the direction perpendicular to the side surface.

The direction of the tilt angle of the LED may be different depending on the LEDs. In FIG. 11 (A), it can be seen that the tilt angle direction of the red LED 210 is different from the tilt angle direction of the blue LED 230 described above.

Referring to FIG. 11(A), when the first-type electrode is a positive electrode and the second-type electrode is a negative electrode, the red LED 210 may be tilted toward the negative electrode with respect to the light emitting surface (top surface). Referring to FIG. 11(B), the green LED 220 may be tilted toward the positive electrode with respect to the LED (top surface). Referring to FIG. 11(C), the blue LED 230 may be tilted toward the positive electrode with respect to the light emitting surface (top surface) in the same manner as the green LED 220.

Meanwhile, referring to FIG. 13(A), when the first-type electrode is a positive electrode and the second-type electrode is a negative electrode, the red LED 210 may be tilted toward the positive electrode with respect to the light emitting surface (top surface). Referring to FIG. 13(B), the green LED 220 may be tilted toward the negative electrode with respect to the light emitting surface (top surface). Additionally, referring to FIG. 13(C), the blue LED 230 may be tilted toward the negative electrode with respect to the light-emitting surface (top surface) in the same manner as the green LED 220.

In this way, the tilt angles of the LEDs (210, 220, 230) may be determined in various ways depending on manufacturing conditions and states. The tilt angles of the LEDs (210, 220, 230) shown in FIGS. 11 to 13 and the arrangements of the positive electrodes (+) and negative electrodes (-) of the LEDs (210, 220, 230) shown in FIGS. 11 to 13 are merely examples, and other arrangements not shown in FIGS. 11 to 13 may also be present as needed. According to the embodiments of the present disclosure, the LEDs (210, 220, 230) having various tilt angles and arrangements of the positive electrode (+) and negative electrodes (-) can be used.

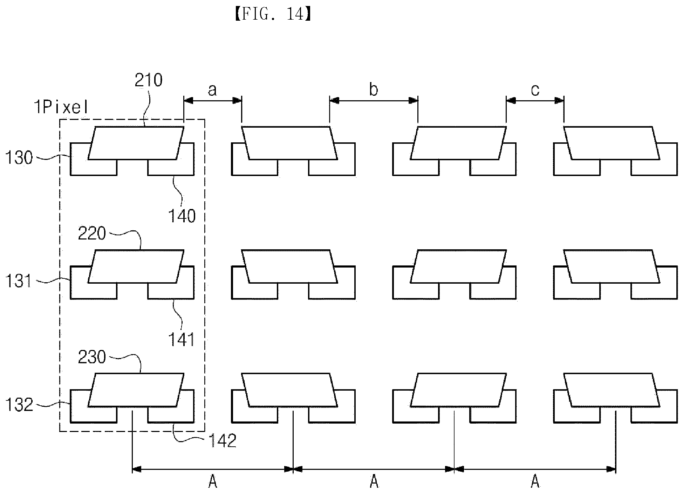

FIG. 14 is a schematic diagram showing an example of subpixel arrangement of a display device using semiconductor LEDs each having a tilt angle.

Referring to FIG. 14, the wiring substrate 100 may be omitted, and the arrangement of the electrode pads (130, 140/131, 141/132, 142) and the arrangement of the LEDs (210, 220, 230) connected to the electrode pads (130, 140/131, 141/132, 142) are schematically illustrated.

Here, the red LEDs 210 may be arranged in one direction, and the green LEDs 220 may be arranged in one direction adjacent to the arrangement of the red LEDs 210. In addition, the blue LEDs 230 may be arranged in one direction adjacent to the arrangement of the green LEDs 220. At this time, each of the adjacent LEDs (210, 220, 230) may form a subpixel. For example, a set of the red LED 210, the green LED 220, and the blue LED 230 that are adjacent to each other may form one pixel.

FIG. 14 shows a state in which the above-mentioned electrode pads (130, 140/131, 141/132, 142) are arranged at regular intervals (A). That is, the spacing of the electrode pads (130, 140/131, 141/132, 142) to which the LEDs (210, 220, 230) are connected may be set to the subpixel pitch according to the bonding surfaces 234 of the LEDs (210, 220, 230).

In this way, in a state in which the electrode pads (130, 140/131, 141/132, 142) are arranged at regular intervals (A), the subpixel pitch may vary on the light emitting surfaces (E) of the LEDs (210, 220, 230) due to characteristics of the LEDs each having a tilt angle.

Referring to FIG. 14, it can be seen that the electrode pads (130, 140/131, 141/132, 142) are spaced apart from each other by a constant distance (A), but the intervals (a, b, c) between the LEDs (210, 220, 230) are changed. Here, it can be seen that the distance (b) between the light emitting surfaces of the second and third LEDs is longer than the distance (a) between the light emitting surfaces of the first and second LEDs. Additionally, "c" indicating the gap between the light emitting surfaces of the third and fourth LEDs may be smaller than "b". In practice, "a" and "c" may be the same.

As described above, depending on the tilt angles (α) of the LEDs (210, 220, 230), a difference in length/area between the bonding surface 234 and the light emitting surface (E) of the LEDs (210, 220, 230) may occur by the shift F or F'. Accordingly, the gap between the light emitting surfaces (E) can be increased or decreased by the shift F or F'.

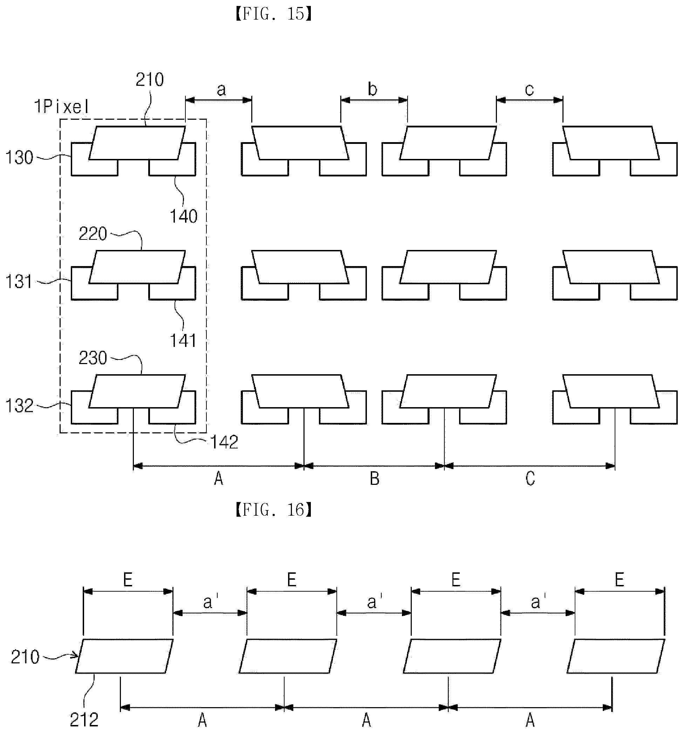

FIG. 15 is a schematic diagram illustrating an example of the subpixel arrangement of the display device using semiconductor LEDs each having a tilt angle according to a first embodiment of the present disclosure.

As described above, in the process of manufacturing a display device using the LEDs (210, 220, 230), when the spacing between the electrode pads (130, 140/131, 141/132, 142) to which the LEDs (210, 220, 230) are connected is set to the subpixel pitch in response to the light emitting surfaces (E) of the LEDs (210, 220, 230), a uniform subpixel pitch can be secured regardless of the shifts (F, F') when viewed from the light emitting surfaces (E) of the LEDs (210, 220, 230). In this case, the spacing between the electrode pads (130, 140/131, 141/132, 142) may vary according to the result of compensating for the shifts (F, F').

Referring to FIG. 15, "a" indicating the distance between the light emitting surfaces of the first and second LEDs, "b" indicating the distance between the light emitting surfaces of the second and third LEDs, and "c" indicating the distance between the light emitting surfaces of the third and fourth LEDs may be adjusted to be identical to each other, so that the spacing between the electrode pads (130, 140/131, 141/132, 142) may vary depending on the positions of the electrode pads. That is, the spacing between the electrode pads (130, 140/131, 141/132, 142) may change depending on the positions of the electrode pads.

Meanwhile, when comparing the first distance between the bonding surfaces of the first and second LEDs that are successively positioned with the second distance between the bonding surfaces of the second and third LEDs, the first distance and the second distance may be different from each other. This structure may correspond to the distance between the corresponding electrode pads.

In this way, the distance between the adjacent LEDs based on the light emitting surfaces of the LEDs may be the same, but the distance between the adjacent LEDs may change based on the bonding surface of the LEDs.

As described above with reference to FIGS. 2 and 3, the LEDs (210, 220, 230) are arranged symmetrically to each other in one direction. This structure may correspond to a state in which the LEDs are arranged in parallel in one direction.

In this way, the state in which each of the LEDs (210, 220, 230) has an inclined crystal structure is schematically shown. In particular, when comparing any two pixels that are adjacent to each other, the two LEDs (for example, the first and second LEDs) belonging to the two pixels may have tilt angles that are symmetrical to each other. For example, the first and second LEDs may be inclined at an angle in such a way that the light emitting surfaces of the first and second LEDs move closer to each other as the light emitting surfaces of the first and second LEDs move farther away from the pad. Further, the second and third LEDs may have an angle inclined in a direction in which the light emitting surfaces of the second and third LEDs move farther away from each other as the light emitting surfaces move farther away from the pad.

Referring to FIG. 15, from the viewpoint of the arrangement of LEDs that emit light of the same color, the intervals (a, b, c) between the light emitting surfaces are determined to be the same (a = b = c). In this case, the spacings (A, B, C) of the electrode pads (130, 140/131, 141/132, 142) may be different from each other.

The pad spacing (A) between the two LEDs corresponding to an angle inclined in a direction along which the light emitting surfaces move closer to each other in proportion to the increasing distance away from the pad may be greater than the pad spacing (B) between two LEDs corresponding to the angle inclined in a direction along which the light emitting surfaces move farther away from the pad. Such pad spacings (A, B) may be arranged repeatedly. In other words, referring to FIG. 15, the spacing (A) between the pads corresponding to the first and second LEDs may be equal to the spacing (C) between the pads corresponding to the third and fourth LEDs.

As described above, the display device according to an embodiment of the present disclosure may include a wiring substrate 100 (see FIG. 2) on which a plurality of unit pixels is defined, electrode pads (130, 140/131, 141/132, 142) disposed on the unit pixels to define a plurality of unit subpixels, and light emitting diodes (210, 220, 230) that are electrically connected on the electrode pads (130, 140/131, 141/132, 142) such that each LED has a side surface with a tilt angle biased to one side.

According to an exemplary embodiment, two adjacent LEDs are arranged symmetrically with respect to the tilt angle, and the distances (A, B, C) between two adjacent electrode pads may be changed. The arrangement of these LEDs and electrode pads may correspond to the arrangement of first LEDs that emit light of a first color in the first direction, for example, may correspond to red LEDs that emit red light. Additionally, the arrangement of these LEDs and electrode pads may correspond to the arrangement of second LEDs that emit light of a second color in the second direction, for example, may correspond to green LEDs that emit green light. Additionally, the arrangement of these LEDs and electrode pads may correspond to the arrangement of third LEDs that emit light of a third color in the third direction, for example, may correspond to blue LEDs that emit blue light.

Here, the first direction may refer to the direction in which LEDs emitting light of the same color are arranged. The second direction may be substantially the same (parallel) to the first direction, but may be spaced apart from the first direction by a subpixel interval (i.e., the spacing between subpixels). Likewise, the third direction may be substantially identical (parallel) to the second direction but may be spaced apart from the second direction by a subpixel interval.

On the other hand, pixel units may be formed in a direction crossing the first, second, and third directions. For example, referring to FIG. 15, the left three LEDs (210, 220, 230) shown in FIG. 15 may form one pixel.

In this way, with respect to the arrangement of the LEDs (210, 220, 230) that emit light of the same color, two adjacent LEDs may be located symmetrically with respect to the tilt angle, so that the opposing (or facing) LEDs have the same electrode polarity as the two adjacent LEDs and the distance between two adjacent electrode pads (130, 140/131, 141/132, 142) may vary depending on the arrangement direction of the LEDs that emit light of the corresponding color.

In an exemplary embodiment, the electrode polarities of the LEDs (210, 220, 230) connected to two adjacent electrode pads may be arranged such that the same polarities face each other. For example, when a first-type electrode (for example, an N-type electrode) and a second-type electrode (for example, a P-type electrode) are located at a position where the LEDs (210, 220, 230) are fixed with respect to a tilt angle, the two adjacent LEDs are arranged such that tilt angles are symmetrical to each other and the polarities of the facing positions of the two adjacent LEDs may be the same.

FIGS. 16 to 18 are schematic diagrams illustrating examples of arrangement of light emitting diodes (LEDs) each having a tilt angle. FIGS. 16 to 18 exemplarily illustrate examples of the red LEDs 210 each having a light emitting surface (E) and a bonding surface 212, but the concepts of FIGS. 16 to 18 may also be equally applied to green and blue LEDs.

FIG. 16 shows an example in which the LEDs 210 having a tilt angle are arranged in the same direction and at regular intervals (a') based on the tilt angle/electrode position. In this case, the distance between the center points of the bonding surfaces 212 may be the same distance denoted by 'A'. Accordingly, the distance between the center points of the electrode pads 130 and 140 may also be the same. In this case, the distance between the light emitting surfaces (E) of two adjacent LEDs 210 may be the same distance denoted by (a').

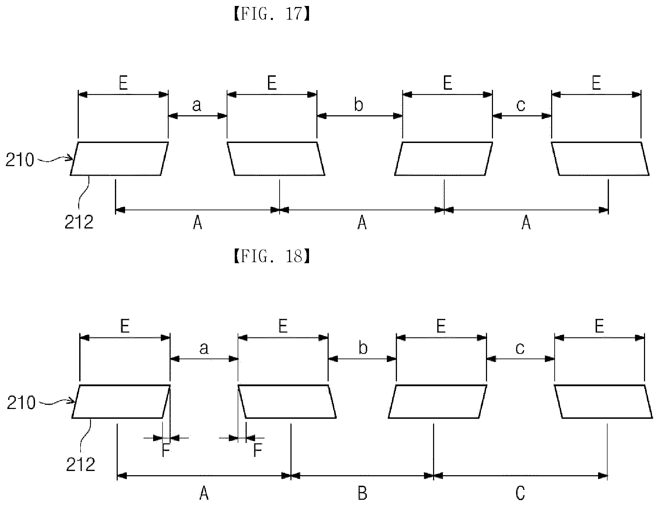

The case of FIG. 17 may correspond to the case described above with reference to FIG. 14. That is, an example is shown in which the LEDs 210 having a tilt angle are arranged in a symmetrical direction and at regular intervals (a') based on the tilt angle/electrode position. In this case, the distance between the center points of the bonding surfaces 212 may be the same distance denoted by 'A'. Accordingly, the distance between the center points of the electrode pads 130 and 140 may also be the same. In this case, the distance between the light emitting surfaces (E) may vary (a, b, c, b > a, c, a = c).

The case of FIG. 18 may correspond to the case described above with reference to FIG. 15. That is, an example is shown in which the LEDs 210 having a tilt angle are arranged in a symmetrical direction and at different intervals (a, b, c) based on the tilt angle/electrode position. In this case, the distance between the center points of the bonding surfaces 212 may be changed to A → B → C. Accordingly, the distance between the center points of the electrode pads 130 and 140 may also be equally changed.

As described above, the distance between the center points of the bonding surfaces 212 of the LEDs 210 may be changed so that the distances (a, b, c) between the light emitting surfaces (E) are the same (a = b = c).

Accordingly, the distance between the center points of the electrode pads 130 and 140 may also be changed so that the distances (a, b, c) between the light emitting surfaces (E) are the same (a = b = c, A > B, C > B, A = C).

At this time, the distance between the center points of the electrode pads 130 and 140 or the distance between the center points of the bonding surfaces 212 of the LEDs 210 may be changed to compensate for the shift (F) caused by the tilt angle. In other words, the distance (A, B, C) between two adjacent electrode pads may be changed by the shift (F) caused by the tilt angle.

For example, the distances (A, B, C) between two adjacent electrode pads (between the center points of the bonding surfaces of the LEDs) may include the first distance (A) and the second distance (B) different from each other. For example, the first distance (A) and the second distance (B) may be located repeatedly (A = C).

In an exemplary embodiment, the distance between two adjacent electrode pads (between the center points of the bonding surfaces of the LEDs) may include the first distance (A) corresponding to a tilt angle at which the light emitting surfaces (E) of the light emitting diodes 210 approach each other; and a second distance (B) corresponding to a tilt angle at which the light emitting surfaces (E) of the LEDs 210 move farther away from each other. In this case, the second distance B may be smaller than the first distance A (i.e., A > B).

From another perspective, adjacent LEDs arranged in the first direction in which the first LEDs that emit light of the first color are arranged are arranged symmetrically with respect to the tilt angle so that the electrode polarities of the opposing LEDs are the same, and the subpixel pitch defined by the distance between the electrode pads may vary depending on the direction of the tilt angle.

In other words, for example, when the red LEDs 210 that emit red light are arranged adjacent to each other in one direction, the adjacent LEDs 210 are symmetrically arranged with respect to the tilt angle so that the LEDs 210 have the same electrode polarity. The subpixel pitches (A, B, C) defined by the distance between the electrode pads (or the distance between the center points of the bonding surfaces of the light emitting diodes 210) may vary depending on the direction of the tilt angle.

In an example embodiment, the subpixel pitches (A, B, C) may include the first subpixel pitch (A) and the second subpixel pitch (B). For example, the first subpixel pitch (A) and the second subpixel pitch (B) may be alternately located in only one direction (A= C).

In other words, the subpixel pitches (A, B, C) may include the first subpixel pitch (A) corresponding to the tilt angle at which the light emitting surfaces (E) of the light emitting diodes 210 approach each other; and the second subpixel pitch (B) corresponding to the tilt angle at which the light emitting surfaces (E) of the LEDs 210 move farther away from each other. In this case, the second subpixel pitch (B) may be smaller than the first subpixel pitch (A) (i.e., A> B).

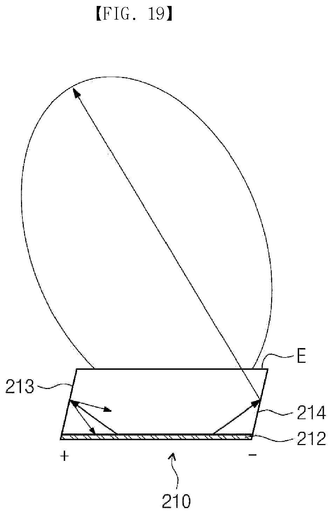

FIG. 19 is a conceptual diagram showing a light emission pattern by the light emitting diode having a tilt angle.

Referring to FIG. 19, the LED 210 having a tilt angle, specifically, the LED 210 having a side angle inclined (tilt) angle other than 90 degrees is schematically shown.

Hereinafter, the red LED 210 will be described as an example, but this description can also be equally applied to the green LED 220 and the blue LED 230.

The light emitting layer of the LED 210 may be located close to the bonding surface 212. Most of the upper side of the LED 212 may occupy a large thickness. Light generated from this light emitting layer may be emitted toward the light emitting surface (E). At this time, there is light that directly reaches the light emitting surface (E) and is then emitted through this light emitting surface (E). However, in theory, light is emitted in all directions from the light-emitting layer, so that there is light emitted toward the first side 213 and the second side 214.

As described above, due to a tilt angle from among light beams emitted toward the first side surface 213 and the second side surface 214, a portion of light beams emitted toward the first side surface 213 may not pass through the first side surface 213 due to a small angle of incidence, and may be totally reflected into the LED 210.

On the other hand, even if light emitted toward the second side surface 214 is totally reflected from the second side surface 214, light may be reflected in the diagonal direction (i.e., the direction toward the first side surface 213) due to the tilt angle and may be emitted through the light emitting surface (E). Accordingly, in the structure of the LED 210 in which the light emitting surface (E) is inclined toward the second side surface 214, the light emitting pattern may be formed in an oval shape inclined toward the first side surface 213 opposite to the second side surface 214. This is one of the reasons why the LED 210 with a tilt angle exhibits an asymmetric light emission pattern.

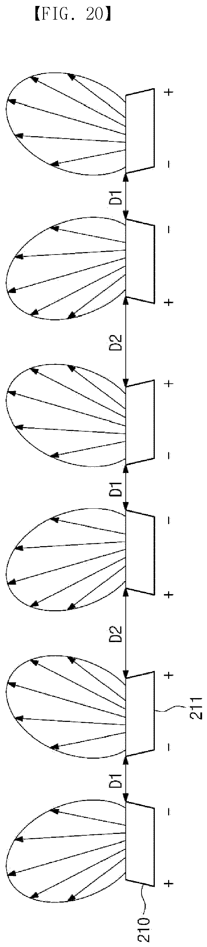

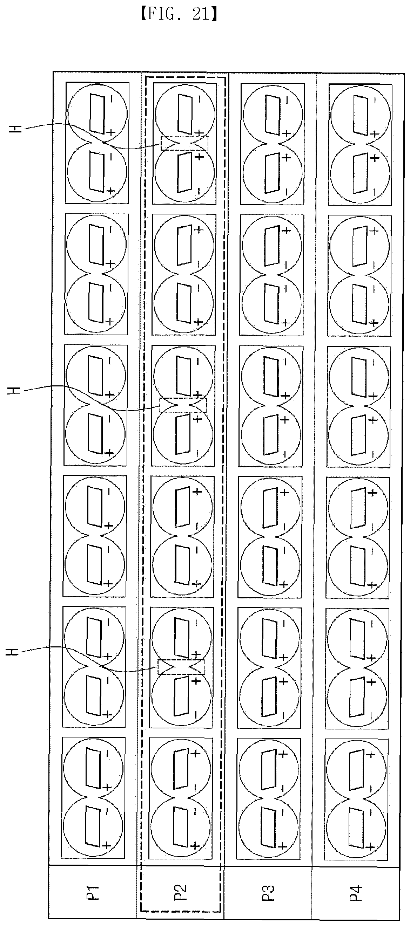

FIG. 20 is a view schematically illustrating light distribution of the display device according to the arrangement of FIG. 14. FIG. 21 is a view illustrating a microscopic analysis showing actual light emission of the display device according to the arrangement of FIG. 14.

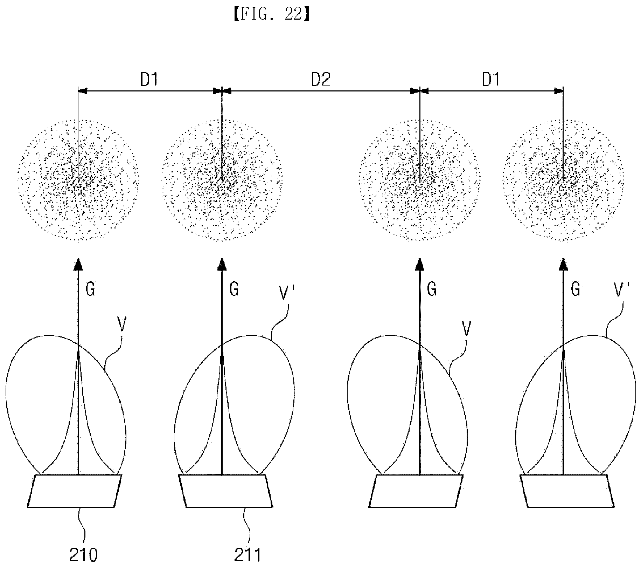

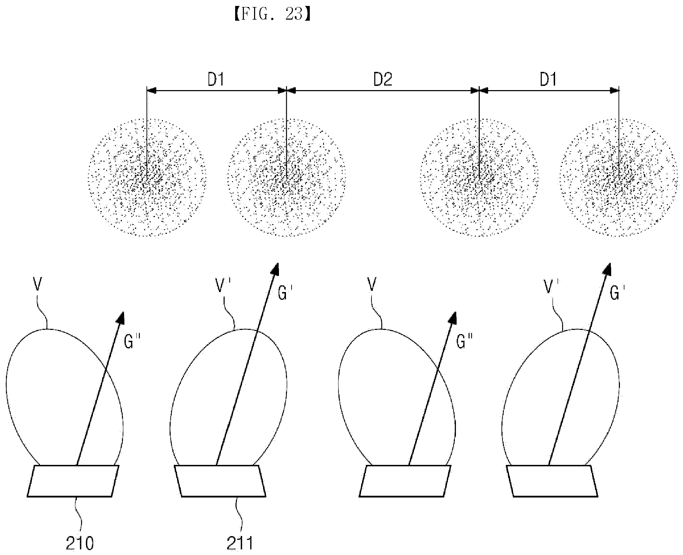

FIG. 22 is a view illustrating light distribution viewed from the front of the display device according to the arrangement of FIG. 14 and a schematic diagram thereof. FIG. 23 is a view illustrating light distribution viewed from the side of the display device according to the arrangement of FIG. 14 and a schematic diagram thereof.

Referring to FIG. 20, it is shown that asymmetric light distribution of the LEDs 210 having the above-described tilt angle may be offset by the symmetrical arrangement of the LEDs 210 with respect to the tilt angle of the LEDs 210. This is consistent with what was previously described with reference to FIG. 6.

However, based on the light emitting surface (E), it can be seen that the position of the light emitting surface (E) shifts according to the tilt angle, resulting in spacing differences between the LEDs as described above.

For example, it can be seen that the distance between the light emitting surfaces (E) between the first and second LEDs is denoted by D1, but the distance between the light emitting surfaces (E) between the second and third LEDs is denoted by D2. This distance (subpixel pitch) can be repeated as denoted by D1 → D2 → D1 → D2 as shown in FIG. 20.

FIG. 21 is an image formed when light emitted from by two adjacent LEDs is captured using a microscope in a state in which a green pattern is displayed on the display device using the microscope. In FIG. 21, a circular shape is the appearance of an actual luminous green pattern.

Referring to FIG. 21, an image formed by light emission of two adjacent LEDs for four pixel pitches (P1, P2, P3, P4) is shown. Here, since the LEDs that emit light of the same color (for example, green LEDs) are related to the image, the pixel pitch can also be viewed as a subpixel pitch. That is, P2, P3 and P4 shown in FIG. 21 may represent a situation in which light is actually emitted by arrangement of LEDs having different (sub)pixel pitches in a state described above with reference to FIG. 14.

Here, P1 and P2 have the same (sub)pixel pitch, but in the case of P1, the LEDs are arranged in the same direction with respect to the tilt angle. Therefore, although the light emission pattern is non-uniform, the spacings between the light emitting surfaces are identical to each other.

The (sub)pixel pitch may gradually increase in the direction from P2 to P4. Here, in the case of P2, it can be seen that a dark portion (H) becomes visible between the LEDs. In particular, when the light emitting surfaces are arranged to be distant from each other, the dark portion (H) may be visible between the light emitting surfaces.

This may mean that as the pitch becomes finer, the shift caused by the tilt angle may affect the display image. When the (sub)pixel pitch is relatively large, the ratio of the shifted length may be relatively small or negligible, but when the (sub)pixel pitch is relatively small, the ratio of the shifted length becomes relatively large so that the dark portion (H) can be recognized as in the case of P2.

Referring to FIG. 22, the reason why the above phenomenon may occur is schematically explained.

As shown in the arrangement shown in FIG. 14, when the LEDs 210 and 211 are arranged at equal intervals based on the bonding surface, that is, when the LEDs 210 are arranged at the same intervals based on the electrode pad, the interval (pitch) between center points (G) of the LEDs (210, 11) may be repeated as denoted by D1/D2.

Accordingly, dark regions may be visible between relatively long pitches D2 depending on the viewing distance or overall pixel pitch of the display device.

FIG. 22 schematically shows the appearance of light emission of the display device when the display device is viewed from the front. In this case, as described above with reference to FIG. 19, inclined light distribution patterns (V, V') may appear, but when the display device is viewed from the front and the inclined light distribution patterns (V, V') of the display are observed, these inclined distribution patterns (V, V') may not substantially affect the display.

In other words, when the display device is viewed from the front, only the shift of the LED depending on the tilt angle may affect the display, so that the vertical lines affected by the shift of the LED may hardly be visible.

However, when the display device shown in FIG. 23 is viewed from the side direction, that is, at the viewing angle, it can be seen that a brightness difference due to the light emission surface shift phenomenon and light distribution characteristics increases.

For example, when the light distribution pattern (V) and the light emission direction (G") are different from each other (see `210'), the brightness is relatively weakened, but when the light distribution pattern (V') and the light emission direction (G') are the same (see `211'), it can be seen that the brightness increases relatively.

Due to this weighted difference in brightness, vertical lines may be slightly visible at the viewing angle of the display device.

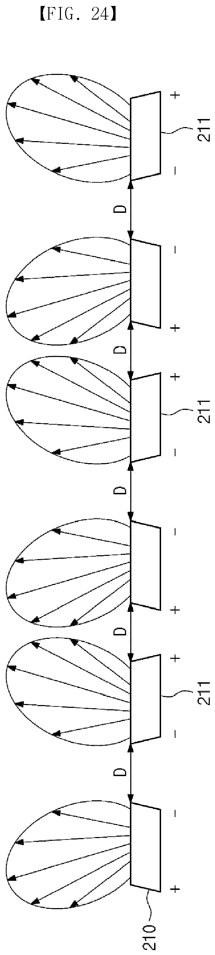

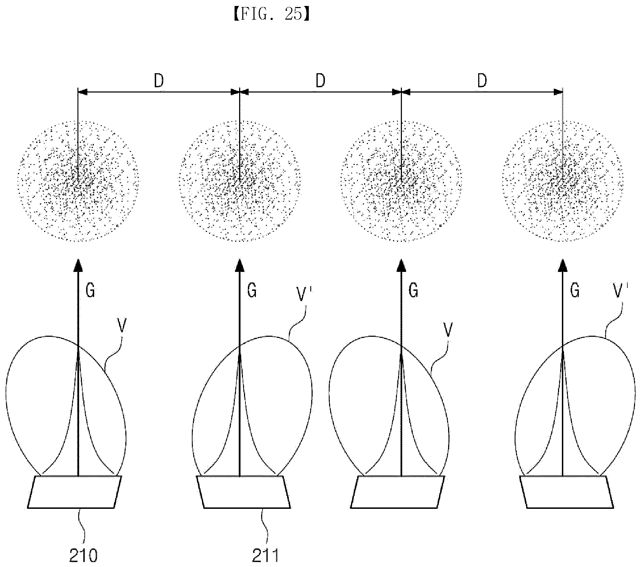

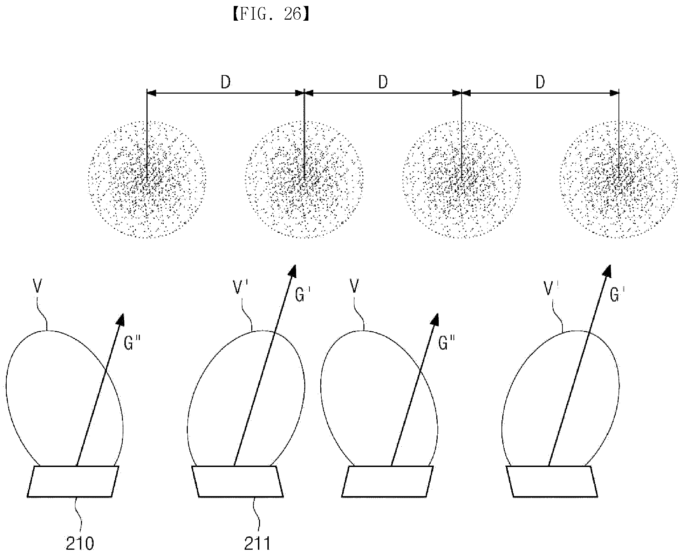

FIG. 24 is a view illustrating light distribution of the display device according to the arrangement of FIG. 15. FIG. 25 is a view illustrating light distribution viewed from the front of the display device according to the arrangement of FIG. 15 and a schematic diagram thereof. FIG. 26 is a view illustrating light distribution viewed from the side of the display device according to the arrangement of FIG. 15 and a schematic diagram thereof.

Referring to FIG. 24, it is shown that the asymmetric light distribution of the LEDs 210 having the tilt angle described above can be offset by the symmetrical arrangement of the LEDs 210 with respect to the tilt angle. This is consistent with what was previously described with reference to FIG. 6.

In addition, it can be seen that no shift occurs in the distance between the light emitting surfaces (E), and the distance between the light emitting surfaces (E) is constant as denoted by 'D'. For example, the distance between the odd LED 210 and the even LED 211 is constant as denoted by 'D'.

Referring to FIG. 25, the reason why the above phenomenon may occur is schematically explained. As shown in the arrangement shown in FIG. 15, when the LEDs (210, 211) are arranged at equal intervals based on the light emitting surface (E), the spacing (pitch) between the light emitting centers (G) of the LEDs (210, 211) can be constant as denoted by 'D'.

Accordingly, dark regions may be visible between relatively long pitches D2 depending on the viewing distance or overall pixel pitch of the display device.

FIG. 22 schematically shows the appearance of light emission when the display device is viewed from the front. In this case, as described above with reference to FIG. 19, inclined light distribution patterns (V, V') appear, but when viewed from the front, the inclined light distribution patterns (V, V') may not substantially affect the display. In addition, since the distance (pitch) between the centers (G) of the LEDs is constant as denoted by 'D', the possibility of obtaining the effect caused by the light distribution patterns (V, V') may be further reduced.

In other words, when the display device is viewed from the front, the shift of the light emitting surface according to the tilt angle may not affect implementation of the display, so that the resulting vertical lines may hardly be visible.

On the other hand, when the display device shown in FIG. 26 is viewed from the side, that is, even at the viewing angle, the distance (pitch) between the centers (G) of the LEDs is constant as denoted by 'D', so that a difference in brightness due to the light distribution characteristics may not appear.

For example, when the light distribution pattern (V) and the light emission direction (G") are different from each other (210), brightness is relatively weakened. In contrast, when the light distribution pattern (V') and the light emission direction (G') are identical to each other (211), it can be seen that brightness increases relatively.

However, this difference in brightness may be weakened due to the constant spacing between the light emitting surfaces (E), and thus vertical lines may not be visible even at the viewing angle of the display device.

As described above with reference to FIGS. 11 and 13, the positions of the electrodes of the LEDs may be different. For example, the red LED 210 may have an electrode arrangement as shown in FIG. 11(A) or as shown in FIG. 13(A). This is the same for the green and blue LEDs 220 and 230.

Accordingly, the arrangement of the LEDs according to the tilt angle may be different for each color. Accordingly, various embodiments are possible. According to various embodiments of the present disclosure, various phenomena that may appear due to the tilt angle or inclined light distribution patterns (V, V') of the LEDs, for example, a phenomenon in which dark regions are visible, a phenomenon in which vertical lines are visible, and a phenomenon in which light is seen irregularly, etc. can be removed effectively. In other words, since the arrangement of the LEDs that emit different colors of light is configured differently, various phenomena that may occur due to the tilt angle or inclined light distribution patterns (V, V') of the LEDs can be effectively offset from each other.

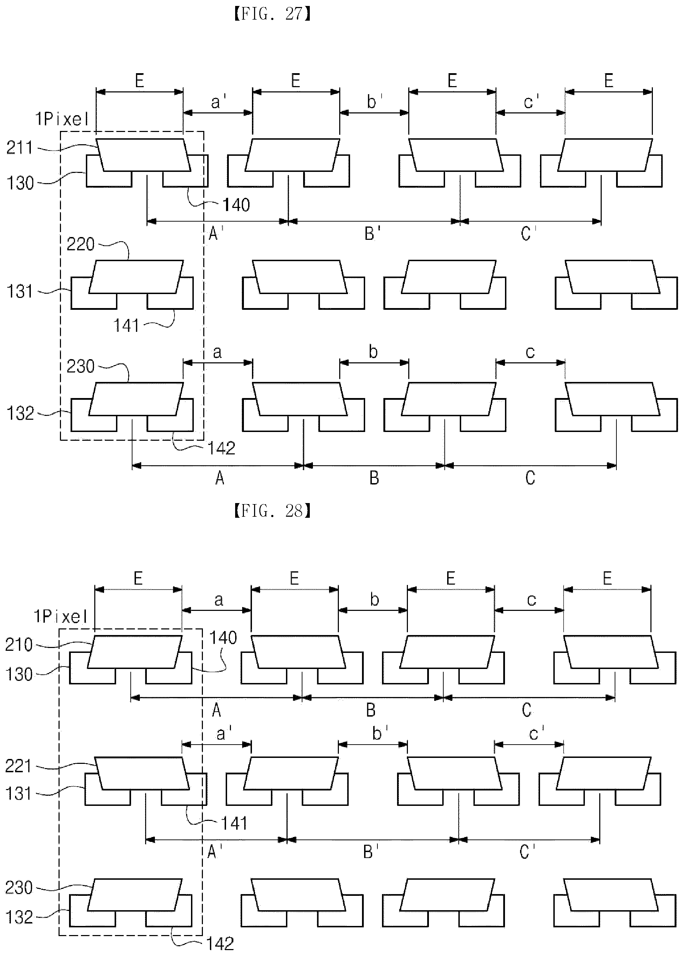

This will be described below with reference to FIGS. 27 to 32.

FIG. 27 is a schematic diagram illustrating the subpixel arrangement of a display device using semiconductor LEDs each having a tilt angle according to a second embodiment of the present disclosure.

Referring to FIG. 27, the arrangement of the green and blue LEDs 220 and 230 is the same as that shown in FIG. 15. However, the arrangement of the red LED 211 is configured such that the first-type electrode (e.g., N-type electrode) and the second-type electrode (e.g., P-type electrode) of the first LED 211 have tilt angles that are gradually biased to the left as the distance to the light emitting surface (E) becomes shorter.

In this case, in the arrangement of the green and blue LEDs 220 and 230, the intervals (a, b, c) between the light emitting surfaces (E) are all the same (a = b = c), and the distance between the centers of the electrode pads (131, 141/132, 142) is variable (A > B, A = C).

However, the tilt angle of the red LED 211 is opposite to those of the adjacent green and blue LEDs 220 and 230. At this time, the arrangement of the red LED 211 is configured such that the intervals (a', b', c') between the light emitting surfaces (E) are all the same (a' = b' = c') and the distances between the centers of the electrode pads (130, 140) are variable (A' > B', A' = C').

At this time, the distances (A', B', C') between the centers of the electrode pads (130, 140) for the red LED 211 may become different from the distances (A, B, C) between the centers of the electrode pads (131, 141/132, 142) for the green and blue LEDs (220, 230). At this time, in some cases, A may be equal to B'.

FIG. 28 is a schematic diagram illustrating the subpixel arrangement of the display device using semiconductor LEDs each having a tilt angle according to a third embodiment of the present disclosure.

Referring to FIG. 28, the arrangement of the red and blue LEDs (210, 230) is the same as that shown in FIG. 15. However, the arrangement of the red LED 211 is configured such that the first-type electrode (e.g., N-type electrode) and the second-type electrode (e.g., P-type electrode) of the first LED 221 have tilt angles that are gradually biased to the left as the distance to the light emitting surface (E) becomes shorter.

In this case, in the arrangement of the red and blue LEDs 210 and 230, the intervals (a, b, c) between the light emitting surfaces (E) are all the same (a = b = c), and the distance between the centers of the electrode pads (131, 141/132, 142) is variable (A > B, A= C).

However, the tilt angle of the green LED 221 is opposite to those of the adjacent red and blue LEDs 210 and 230. At this time, the arrangement of the green LED 221 is configured such that the intervals (a', b', c') between the light emitting surfaces (E) are all the same (a' = b' = c') and the distances between the centers of the electrode pads (131, 141) are variable (A' > B', A' = C').

At this time, the distances (A', B', C') between the centers of the electrode pads (131, 141) for the green LED 221 may become different from the distances (A, B, C) between the centers of the electrode pads (130, 140/132, 142) for the red and blue LEDs (210, 230). At this time, in some cases, A may be equal to B'.

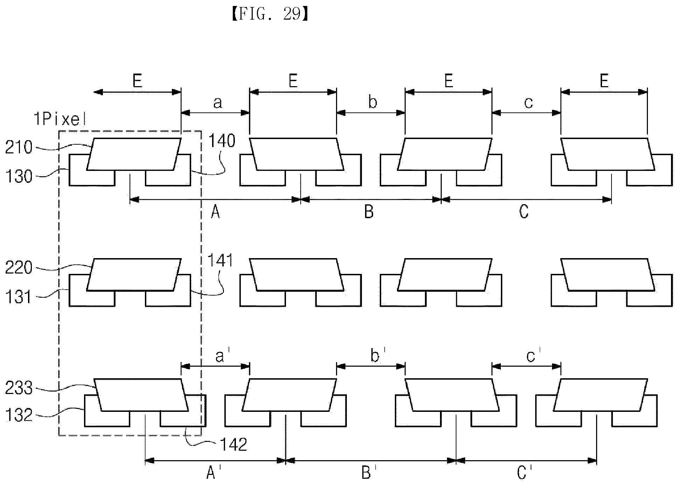

FIG. 29 is a schematic diagram illustrating the subpixel arrangement of the display device using semiconductor LEDs each having a tilt angle according to a fourth embodiment of the present disclosure.

Referring to FIG. 29, the arrangement of the red and green LEDs (210, 220) is the same as that shown in FIG. 15. However, the arrangement of the blue LED 233 is configured such that the first-type electrode (e.g., N-type electrode) and the second-type electrode (e.g., P-type electrode) of the first LED 233 have tilt angles that are gradually biased to the left as the distance to the light emitting surface (E) becomes shorter.

In this case, in the arrangement of the red and green LEDs 210 and 220, the intervals (a, b, c) between the light emitting surfaces (E) are all the same (a = b = c), and the distance between the centers of the electrode pads (130, 140/131, 141) is variable (A > B, A = C).

However, the tilt angle of the blue LED 233 is opposite to those of the adjacent red and green LEDs 210 and 220. At this time, the arrangement of the blue LED 233 is configured such that the intervals (a', b', c') between the light emitting surfaces (E) are all the same (a' = b' = c') and the distances between the centers of the electrode pads (132, 142) are variable (A' > B', A' = C').

At this time, the distances (A', B', C') between the centers of the electrode pads (132, 142) for the blue LED 233 may become different from the distances (A, B, C) between the centers of the electrode pads (130, 140/131, 141) for the red and green LEDs (210, 220). At this time, in some cases, A may be equal to B'.

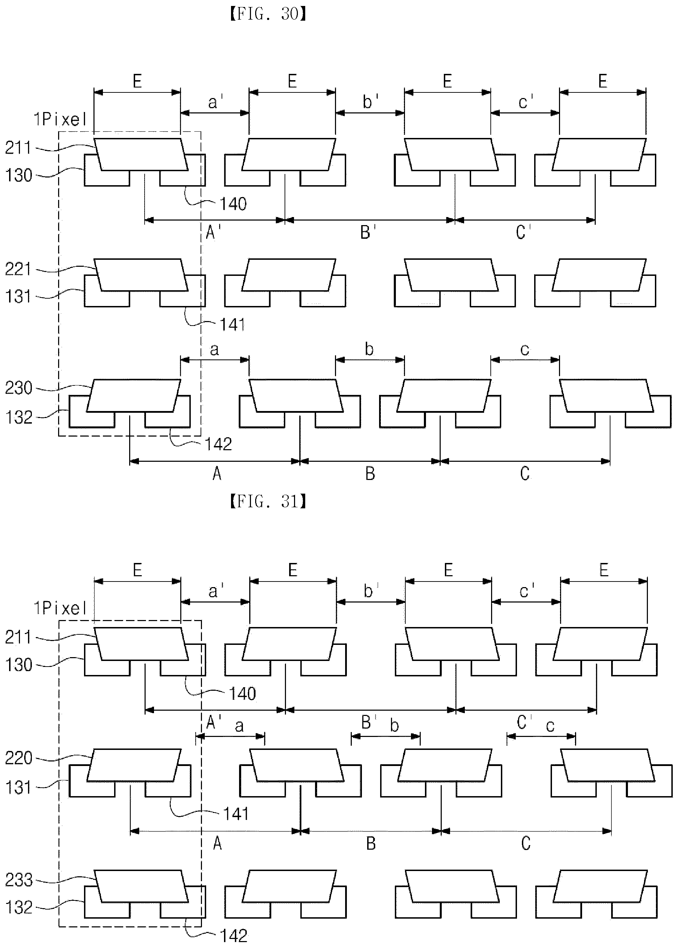

FIG. 30 is a schematic diagram illustrating the subpixel arrangement of the display device using semiconductor LEDs each having a tilt angle according to a fifth embodiment of the present disclosure.

Referring to FIG. 30, the arrangement of the blue LED 230 is the same as that shown in FIG. 15. However, the arrangement of the green and red LEDs (211, 221) is configured such that the first-type electrode (e.g., N-type electrode) and the second-type electrode (e.g., P-type electrode) of the first LED 221 have tilt angles that are gradually biased to the left as the distance to the light emitting surface (E) becomes shorter.

In this case, in the arrangement of the blue LED 230, the intervals (a, b, c) between the light emitting surfaces (E) are all the same (a = b = c), and the distance between the centers of the electrode pads (132, 142) is variable (A > B, A= C).

However, the tilt angles of the red and green LEDs (211, 221) are opposite to those of the adjacent blue LED 230. At this time, the arrangement of the red and green LEDs (211, 221) is configured such that the intervals (a', b', c') between the light emitting surfaces (E) are all the same (a' = b' = c') and the distances between the centers of the electrode pads (130, 140/131, 141) are variable (A' > B', A' = C').

At this time, the distances (A', B', C') between the centers of the electrode pads (130, 140/131, 141) for the red and green LEDs (211, 221) may become different from the distances (A, B, C) between the centers of the electrode pads (132, 142) for the blue LED 230. At this time, in some cases, A may be equal to B'.

FIG. 31 is a schematic diagram illustrating the subpixel arrangement of the display device using semiconductor LEDs each having a tilt angle according to a sixth embodiment of the present disclosure.

Referring to FIG. 31, the arrangement of the green LED 220 is the same as that shown in FIG. 15. However, the arrangement of the red and blue LEDs (211, 233) is configured such that the first-type electrode (e.g., N-type electrode) and the second-type electrode (e.g., P-type electrode) of the first LEDs (211, 233) have tilt angles that are gradually biased to the left as the distance to the light emitting surface (E) becomes shorter.

In this case, in the arrangement of the green LED 220, the intervals (a, b, c) between the light emitting surfaces (E) are all the same (a = b = c), and the distance between the centers of the electrode pads (131, 141) is variable (A > B, A= C).

However, the tilt angles of the red and blue LEDs (211, 233) are opposite to those of the adjacent blue LED 220. At this time, the arrangement of the red and blue LEDs (211, 233) is configured such that the intervals (a', b', c') between the light emitting surfaces (E) are all the same (a' = b' = c') and the distances between the centers of the electrode pads (130, 140/132, 142) are variable (A' > B', A' = C').

At this time, the distances (A', B', C') between the centers of the electrode pads (130, 140/132, 142) for the red and blue LEDs (211, 233) may become different from the distances (A, B, C) between the centers of the electrode pads (131, 141) for the green LED 220. At this time, in some cases, A may be equal to B'.

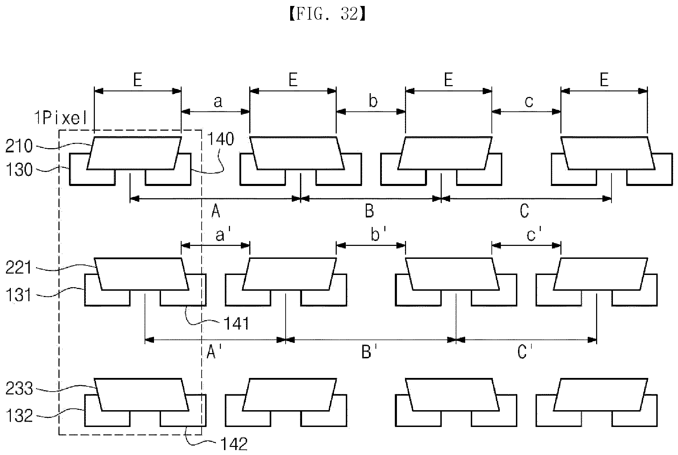

FIG. 32 is a schematic diagram illustrating the subpixel arrangement of the display device using semiconductor LEDs each having a tilt angle according to a seventh embodiment of the present disclosure.

Referring to FIG. 32, the arrangement of the red LED 210 is the same as that shown in FIG. 15. However, the arrangement of the green and blue LEDs (221, 233) is configured such that the first-type electrode (e.g., N-type electrode) and the second-type electrode (e.g., P-type electrode) of the first LEDs (221, 233) have tilt angles that are gradually biased to the left as the distance to the light emitting surface (E) becomes shorter.

In this case, in the arrangement of the red LED 210, the intervals (a, b, c) between the light emitting surfaces (E) are all the same (a = b = c), and the distance between the centers of the electrode pads (130, 140) is variable (A> B, A= C).

However, the tilt angles of the green and blue LEDs (221, 233) are opposite to those of the adjacent red LED 210. At this time, the arrangement of the green and blue LEDs (221, 233) is configured such that the intervals (a', b', c') between the light emitting surfaces (E) are all the same (a' = b' = c') and the distances between the centers of the electrode pads (131, 141/132, 142) are variable (A' > B', A' = C').

At this time, the distances (A', B', C') between the centers of the electrode pads (131, 141/132, 142) for the green and blue LEDs (221, 233) may become different from the distances (A, B, C) between the centers of the electrode pads (130, 140) for the red LED 210. At this time, in some cases, A may be equal to B'.

In this way, when light emitting diodes (LEDs) are symmetrically located in pairs with the adjacent pixels, the biased light distributions (a, b) resulting from the crystal structure of the LEDs can be offset from each other to achieve uniform light distribution.

Accordingly, the problem of colors appearing differently depending on the viewing direction when looking at the display device from the outside can also be solved.

Meanwhile, when the display device is viewed from the side, that is, even at the viewing angle, the distance (pitch) between the light emitting centers (G) is constant, as denoted by 'D', and thus a difference in brightness due to light distribution characteristics may not appear.

In addition, according to various embodiments, various phenomena that may appear due to the tilt angle or inclined light distribution pattern (V, V') of the light emitting diode, for example, a phenomenon in which dark regions are visible, a phenomenon in which vertical lines are visible, and a phenomenon of light unevenness, etc. can be effectively removed.

The above-described phenomena show that after placing a cover film on the LED array, a slight difference in light intensity between red light, green light, and blue light is further reduced, and light is emitted uniformly.

The above description is merely illustrative explanation of the technical idea of the present disclosure, and various modifications and variations will be possible to those skilled in the art without departing from the essential characteristics of the present disclosure.

Therefore, embodiments disclosed in the present disclosure are not intended to limit the technical idea of the present disclosure, but to describe, and the scope of the technical idea of the present disclosure is not limited by such embodiments.

The scope of protection of the present disclosure should be interpreted by the claims below, and all technical ideas within the scope equivalent thereto should be construed as being included in the scope of the present disclosure.

## Claims

1. A display device using light emitting diodes comprising:
a wiring substrate in which a plurality of unit pixels is defined;
at least one electrode pad disposed in each of the unit pixels to define a plurality of unit sub-pixels; and
at least one light emitting diode configured to have a tilt angle at which a side surface of the light emitting diode is inclined to one side, and a bonding surface electrically connected to the electrode pad,
wherein
two light emitting diodes adjacent to each other are arranged symmetrically with respect to the tilt angle; and
a distance between two electrode pads adjacent to each other varies depending on positions of the electrode pads.

2. The display device according to claim 1, wherein:
electrode polarities of the light emitting diodes connected to the two adjacent electrode pads are arranged so that the same polarities face each other.

3. The display device according to claim 1, or 2, wherein:
the distance between the two adjacent electrode pads varies by compensating for a shift of a light emitting surface of the light emitting diode with respect to the bonding surface due to the tilt angle.

4. The display device according to claim 1, 2, or 3, wherein:
the distance between the two adjacent electrode pads varies in one direction in which the light emitting diodes that emit light of the same color are disposed.

5. The display device according to any one of claims 1 to 4, wherein:
polarities of the facing light emitting diodes corresponding to the two adjacent electrode pads are identical.

6. The display device according to any one of claims 1 to 5, wherein the distance between the two adjacent electrode pads includes:
a first distance corresponding to a tilt angle at which light emitting surfaces of the light emitting diodes move closer to each other; and
a second distance corresponding to a tilt angle at which light emitting surfaces of the light emitting diode move farther away from each other.

7. The display device according to claim 6, wherein the first distance and the second distance are repeatedly arranged.

8. The display device according to claim 6, or 7 wherein the second distance is smaller than the first distance.

9. The display device according to claim 6, 7, or 8, wherein distances between light emitting surfaces of the light emitting diodes, which correspond to the first distance and the second distance, are equal to each other.

10. The display device according to any one of claims 6 to 9, wherein the distances between bonding surfaces of the light emitting diodes, which correspond to the first distance and the second distance, are different from each other.

11. A display device using light emitting diodes comprising:
a wiring substrate in which a plurality of unit pixels is defined;
at least one electrode pad disposed in each of the unit pixels to define a plurality of unit sub-pixels; and
at least one light emitting diode configured to have a tilt angle at which a side surface of the light emitting diode is inclined to one side, and a bonding surface electrically connected to the electrode pad,
wherein the light emitting diode includes first light emitting diodes configured to emit light of a first color in a first direction,
wherein
the first light emitting diode includes a 1-1^{st} light emitting diode, a 1-2^{nd} light emitting diode, and a 1-3^{rd} light emitting diode that are consecutively arranged; and
a first distance between the 1-1^{st} light emitting diode and the 1-2^{nd} light emitting diode is different from a second distance between the 1-2^{nd} light emitting diode and the 1-3^{rd} light emitting diode.

12. The display device according to claim 11, wherein:
the first distance is a distance between centers of bonding surfaces of the 1-1^{st} light emitting diode and the 1-2^{nd} light emitting diode; and
the second distance is a distance between centers of bonding surfaces of the 1-2^{nd} light emitting diode and the 1-3^{rd} light emitting diode.

13. The display device according to claim 11, or 12, wherein:
a distance between two adjacent electrode pads corresponding to the first light emitting diodes varies depending on positions of the two adjacent electrode pads, and
the distance between the two adjacent electrode pads varies by compensating for a shift of a light emitting surface of the light emitting diode with respect to the bonding surface due to the tilt angle.

14. The display device according to claim 11, 12, or 13, further comprising:
second light emitting diodes configured to emit light of a second color in a second direction; and
third light emitting diodes configured to emit light of a third color in a third direction,
wherein
among the first light emitting diodes, the second light emitting diodes, and the third light emitting diodes, adjacent first, second, and third light emitting diodes form one unit pixel; and
a direction of a tilt angle of each of the second light emitting diodes is different from at least one of a tilt angle of each of the first light emitting diodes and a tilt angle of each of the third light emitting diodes,
in the unit pixel, shifts of light emitting surfaces of the light emitting diodes due to the tilt angle are equal to each other.

15. The display device according to any one of claims 11 to 14, wherein the 1-1^{st} light emitting diode and the 1-2^{nd} light emitting diode are arranged symmetrically with respect to the tilt angle so that electrode polarities in directions facing each other are identical.
